# EUROPEAN PATENT APPLICATION

(11) **EP 4 444 044 A1**
(43) Date of publication of application: **09.10.2024**
(21) Application number: 22898473.8
(22) Date of filing: 16.11.2022
(51) Int. Cl.: H05B 47/16, H05B 45/10, H05B 45/20, H05B 45/30, H05B 45/325, H05B 47/155, H05B 47/19

(54) **LIGHTING SYSTEM, LIGHTING SYSTEM CONTROL METHOD, AND PROGRAM**

(30) Priority: 29.11.2021 JP 2021193457
(71) Applicant: Kyocera Corporation, Kyoto-shi Kyoto 612-8501 (JP)
(72) Inventor: OKAMOTO Tetsuya, Kyoto-shi, Kyoto 612-8501 (JP)
(74) Representative: Viering, Jentschura & Partner mbB Patent- und Rechtsanwälte
(86) International application number: PCT/JP2022/042492
(87) International publication number: WO 2023/095689

(57) **Abstract**

An illumination system includes light sources, a substrate, wavelength converters, a light guide, and a controller. The light sources include a first light source and a second light source. The wavelength converters are on the substrate and include a first wavelength converter and a second wavelength converter. The light guide guides fluorescence emitted from the wavelength converters. When causing each light source to repeat emission and non-emission of excitation light in constant cycles, in an operation period of one cycle, the controller causes the second light source to emit no excitation light toward the second wavelength converter for at least a portion of a first emission period during which the first light source emits excitation light toward the first wavelength converter, and causes the first light source to emit no excitation light toward the first wavelength converter for at least a portion of a second emission period during which the second light source emits excitation light toward the second wavelength converter.

## Description

### CROSS-REFERENCE TO RELATED APPLICATION

This application claims priority to Japanese Patent Application No. 2021-193457 filed on November 29, 2021, the entire disclosure of which is incorporated herein by reference.

### TECHNICAL FIELD

The present disclosure relates to an illumination technique.

### BACKGROUND OF INVENTION

A known device emits light of an intended color, such as white, by mixing light from a light source irradiated on and transmitted through a light emitter unit including multiple different phosphors with fluorescence of two or more colors generated by the different phosphors (refer to, for example, Patent Literature 1).

### CITATION LIST

### PATENT LITERATURE

Patent Literature 1: Japanese Unexamined Patent Application Publication No. 2020-155406

### SUMMARY

One or more aspects of the present disclosure are directed to an illumination system, a control method for an illumination system, and a program.

In one aspect, an illumination system includes a plurality of light sources, a substrate, a plurality of wavelength converters, a light guide, and a controller. The plurality of light sources emits excitation light. The plurality of light sources includes a first light source and a second light source. The plurality of wavelength converters is on the substrate. The plurality of wavelength converters includes a first wavelength converter that emits fluorescence with a first wavelength spectrum in response to excitation light from the first light source and a second wavelength converter that emits fluorescence with a second wavelength spectrum different from the first wavelength spectrum in response to excitation light from the second light source. The light guide guides fluorescence emitted from the plurality of wavelength converters. The controller causes each of the plurality of light sources to repeat emission and non-emission of excitation light in constant cycles. When the controller causes each of the plurality of light sources to repeat emission and non-emission of excitation light in the constant cycles, in an operation period of one cycle, the controller causes the second light source to emit no excitation light toward the second wavelength converter for at least a portion of a first emission period during which the first light source emits excitation light toward the first wavelength converter, and the controller causes the first light source to emit no excitation light toward the first wavelength converter for at least a portion of a second emission period during which the second light source emits excitation light toward the second wavelength converter. The operation period of one cycle is from a first start timing at which the first light source starts a first irradiation toward the first wavelength converter with excitation light to a second start timing at which the first light source starts a second irradiation subsequent to the first irradiation toward the first wavelength converter with excitation light.

In one aspect, a control method for an illumination system including a plurality of light sources, a substrate, a plurality of wavelength converters, a light guide, and the controller includes (a) causing, with the controller, each of the plurality of light sources to repeat emission and non-emission of excitation light in constant cycles. The plurality of light sources emits excitation light. The plurality of light sources includes a first light source and a second light source. The plurality of wavelength converters is on the substrate. The plurality of wavelength converters includes a first wavelength converter that emits fluorescence with a first wavelength spectrum in response to excitation light from the first light source and a second wavelength converter that emits fluorescence with a second wavelength spectrum different from the first wavelength spectrum in response to excitation light from the second light source. The light guide guides fluorescence emitted from the plurality of wavelength converters. The controller controls emission and non-emission of excitation light in each of the plurality of light sources. In (a), the controller causes, in an operation period of one cycle, the controller causes the second light source to emit no excitation light toward the second wavelength converter for at least a portion of a first emission period during which the first light source emits excitation light toward the first wavelength converter, and the controller causes the first light source to emit no excitation light toward the first wavelength converter for at least a portion of a second emission period during which the second light source emits excitation light toward the second wavelength converter. The operation period of one cycle is from a first start timing at which the first light source starts a first irradiation toward the first wavelength converter with excitation light to a second start timing at which the first light source starts a second irradiation subsequent to the first irradiation toward the first wavelength converter with excitation light.

In one aspect, a program is executable by a controller in an illumination system including a plurality of light sources, a substrate, a plurality of wavelength converters, a light guide, and a controller. The program causes the illumination system to function as the illumination system according to the above aspect. The plurality of light sources emits excitation light. The plurality of light sources includes a first light source and a second light source. The plurality of wavelength converters is on the substrate. The plurality of wavelength converters includes a first wavelength converter that emits fluorescence with a first wavelength spectrum in response to excitation light from the first light source and a second wavelength converter that emits fluorescence with a second wavelength spectrum different from the first wavelength spectrum in response to excitation light from the second light source. The light guide guides fluorescence emitted from the plurality of wavelength converters. The controller controls emission and non-emission of excitation light in each of the plurality of light sources.

### BRIEF DESCRIPTION OF THE DRAWINGS

FIG. 1 is a schematic diagram of an illumination system according to a first embodiment.
FIG. 2 is a schematic diagram of a light emitter unit, a converter, and a light guide with example structures.
FIG. 3 is a schematic diagram of the light emitter unit and the converter with example structures.
FIG. 4 is a graph showing periods during which each of multiple light sources emits excitation light in a reference example.
FIG. 5 is a graph showing example periods during which each of multiple light sources emits excitation light.
FIG. 6 is a graph showing example periods during which each of multiple light sources emits excitation light.
FIG. 7 is a graph showing example periods during which each of multiple light sources emits excitation light.
FIG. 8 is a graph showing example periods during which each of multiple light sources emits excitation light.
FIG. 9 is a graph showing example periods during which each of multiple light sources emits excitation light.
FIG. 10 is a graph showing example periods during which each of multiple light sources emits excitation light.
FIG. 11 is a graph showing example periods during which each of multiple light sources emits excitation light.
FIG. 12 is a graph showing example periods during which each of multiple light sources emits excitation light.
FIG. 13 is a graph showing example periods during which each of multiple light sources emits excitation light.
FIG. 14 is a graph showing example periods during which each of multiple light sources emits excitation light.
FIG. 15 is a graph showing example periods during which each of multiple light sources emits excitation light.
FIG. 16 is a graph showing example periods during which each of multiple light sources emits excitation light.
FIG. 17 is a graph showing example periods during which each of multiple light sources emits excitation light.
FIG. 18 is a graph showing example periods during which each of multiple light sources emits excitation light.
FIG. 19 is a graph showing the relationship between the periods during which each of multiple light sources emits excitation light and changes in a load connected to a power supply in a reference example.
FIG. 20 is a graph showing an example relationship between the periods during which each of multiple light sources emits excitation light and the changes in the load connected to the power supply.
FIG. 21 is a graph showing an example relationship between the periods during which each of multiple light sources emits excitation light and the changes in the load connected to the power supply.
FIG. 22 is a schematic diagram of an illumination system according to a first variation.
FIG. 23 is a graph showing example periods during which each of multiple light sources emits excitation light in the illumination system according to the first variation.
FIG. 24 is a schematic diagram of an illumination system according to a second variation.
FIG. 25 is a graph showing example periods during which each of multiple light sources emits excitation light in the illumination system according to the second variation.

### DESCRIPTION OF EMBODIMENTS

A known device emits light of an intended color, such as white, by mixing excitation light from a light source irradiated on and transmitted through a light emitter unit including multiple different phosphors with fluorescence of multiple colors generated by the multiple different phosphors.

This device includes the light emitter unit including multiple different phosphors being mixed. To adjust the color of the light to be emitted to an intended color such as reddish white or bluish white, the content ratios of the respective phosphors in the light emitter unit may be changed. With this method, the color cannot be adjusted using a finished light emitter unit.

To adjust the color, a device may include, for example, a first light source, a first wavelength converter including a first phosphor that emits fluorescence of a first color in response to excitation light from the first light source, a second light source, a second wavelength converter including a second phosphor that emits fluorescence of a second color different from the first color in response to excitation light from the second light source, a third light source, and a third wavelength converter including a third phosphor that emits fluorescence of a third color different from the first color and the second color in response to excitation light from the third light source. This device may adjust the color by, for example, adjusting the emission period and the intensity of excitation light emitted from each of the first light source, the second light source, and the third light source as appropriate and by mixing the fluorescence of the first color emitted from the first wavelength converter, the fluorescence of the second color emitted from the second wavelength converter, and the fluorescence of the third color emitted from the third wavelength converter. The excitation light may be, for example, violet, the first color may be red, the second color may be green, and the third color may be blue.

However, the excitation light irradiated may heat the phosphors, accelerating deterioration of the phosphors.

An illumination system is thus to be improved to reduce deterioration of the phosphors while allowing color adjustment of illumination light.

The inventor of the present disclosure thus has developed a technique for reducing deterioration of the phosphors while allowing the color adjustment of illumination light in an illumination system.

A first embodiment and examples will now be described with reference to the drawings. In the drawings, like reference numerals denote the components with like or similar structures and functions. Such components will not be described repeatedly. The drawings schematically illustrate various structures and functional components.

### 1. First Embodiment

### 1-1. Structure of Illumination System

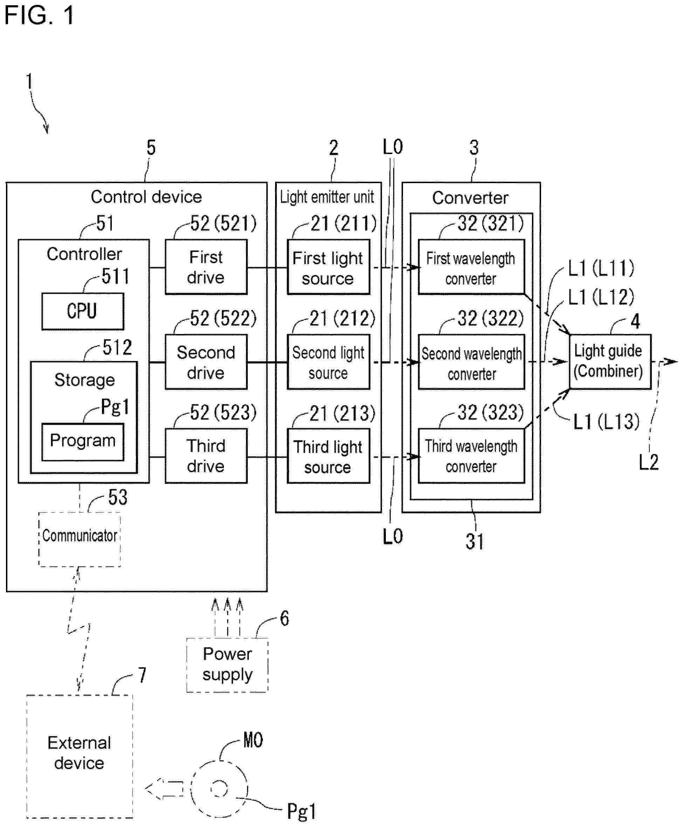

FIG. 1 is a schematic diagram of an illumination system 1 according to a first embodiment. The illumination system 1 can combine multiple colors of fluorescence resulting from excitation light irradiated by multiple light sources toward multiple wavelength converters each including a phosphor. The illumination system 1 can radiate the resulting fluorescence as illumination light into a predetermined space (also referred to as an illumination space). The illumination system 1 may radiate illumination light into an indoor space or an outdoor space. In other words, illumination light radiated by the illumination system 1 may be used indoors or outdoors. Multiple illumination systems 1 may radiate illumination light into a single space. The multiple illumination systems 1 may radiate illumination light into multiple separate spaces.

As illustrated in FIG. 1, the illumination system 1 includes, for example, a light emitter unit 2, a converter 3, a light guide 4, and a control device 5.

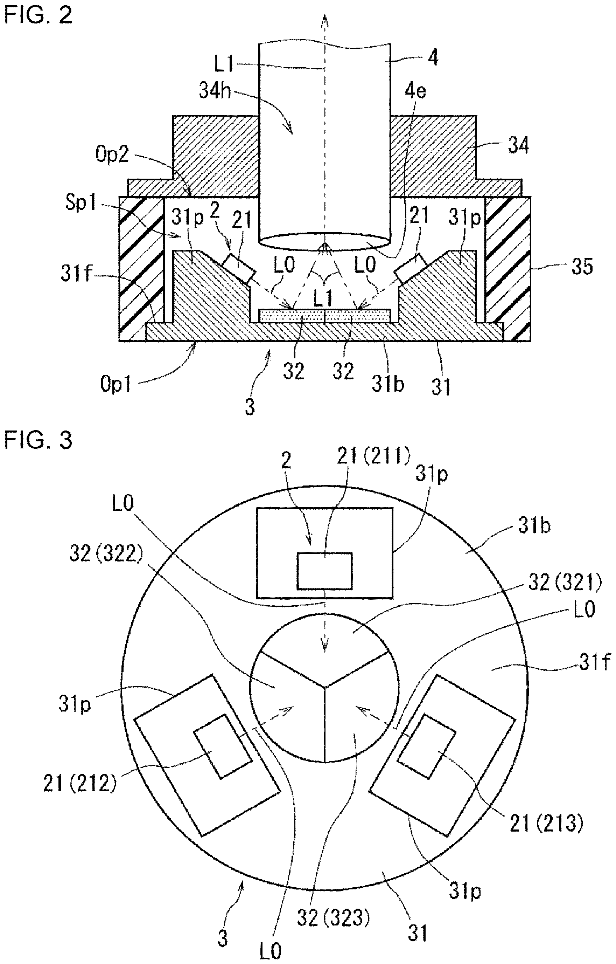

FIG. 2 is a schematic diagram of the light emitter unit 2, the converter 3, and the light guide 4 with example structures. FIG. 2 is a schematic longitudinal sectional view of the light emitter unit 2, the converter 3, and the light guide 4. FIG. 3 is a schematic diagram of the light emitter unit 2 and the converter 3 with example structures. FIG. 3 is a schematic plan view of the light emitter unit 2 and the converter 3.

The light emitter unit 2 includes, for example, multiple light sources 21. The light sources 21 can each emit, for example, excitation light L0. The light sources 21 each include a light emitter. The light emitter includes, for example, a laser diode (LD) chip or a light-emitting diode (LED) chip. Excitation light L0 emitted from the light emitter is monochromatic light such as violet, blue-violet, or blue light. More specifically, the light emitter may be, for example, a gallium nitride (GaN) semiconductor laser that emits violet laser light with 405 nanometers (nm). The light sources 21 include, for example, a first light source 211, a second light source 212, and a third light source 213. In the examples in FIGs. 2 and 3, the light emitter unit 2 is adjacent to the converter 3. In this case, each light source 21 may irradiate the converter 3 with excitation light L0 directly or through an optical element such as a collimator lens.

As illustrated in FIGs. 1 to 3, the converter 3 includes, for example, a substrate 31 and multiple wavelength converters 32.

The wavelength converters 32 are, for example, fixed to the substrate 31. The substrate 31 has, for example, higher thermal conductivity than the wavelength converters 32. The substrate 31 thus functions as a heat sink for cooling the wavelength converters 32. The substrate 31 may be made of, for example, a metal material. Examples of the metal material include copper (Cu), aluminum (Al), magnesium (Mg), gold (Au), silver (Ag), iron (Fe), chromium (Cr), cobalt (Co), beryllium (Be), molybdenum (Mo), tungsten (W), and an alloy of any of these metals. The substrate 31 made of, for example, Cu, Al, Mg, Fe, Cr, Co, or Be as the metal material may be fabricated easily by molding, such as die casting. The substrate 31 made of, for example, Al, Mg, Ag, Fe, Cr, or Co as the metal material may include a surface with an increased reflectance against visible light. The substrate 31 may be made of, for example, a nonmetal material such as silicon nitride (Si₃N₄), carbon (C), or aluminum oxide (Al₂O₃). The nonmetal material may be, for example, crystalline or non-crystalline. The crystalline nonmetal material may be, for example, silicon carbide (SiC) or Si₃N₄.

In the examples in FIGs. 2 and 3, the substrate 31 includes a disk-shaped body 31b and multiple protrusions 3 1p protruding from a first plate surface 31f of the body 31b. A light source 21 is fixed on each protrusion 31p. More specifically, the multiple protrusions 31p include a first protrusion 31p to which the first light source 211 is fixed, a second protrusion 31p to which the second light source 212 is fixed, and a third protrusion 31p to which the third light source 213 is fixed.

The wavelength converters 32 are, for example, on the substrate 31. Each wavelength converter 32 is fixed to the surface of the substrate 31 by, for example, bonding or joining. Each wavelength converter 32 may be fixed in, for example, a recess on the substrate 31. The wavelength converters 32 include, for example, a first wavelength converter 321, a second wavelength converter 322, and a third wavelength converter 323. Each wavelength converter 32 can emit, for example, fluorescence L1 in response to excitation light L0 emitted from the corresponding light source 21.

The first wavelength converter 321 can emit, for example, fluorescence (also referred to as first fluorescence) L11 with a first wavelength spectrum in response to excitation light L0 emitted from the first light source 211. The second wavelength converter 322 can emit, for example, fluorescence (also referred to as second fluorescence) L12 with a second wavelength spectrum different from the first wavelength spectrum in response to excitation light L0 emitted from the second light source 212. The third wavelength converter 323 can emit, for example, fluorescence (also referred to as third fluorescence) L13 with a third wavelength spectrum different from the first wavelength spectrum and the second wavelength spectrum in response to excitation light L0 emitted from the third light source 213.

The first fluorescence L11 and the second fluorescence L12 may have, for example, color temperatures different from each other. The third fluorescence L13 may have, for example, a color temperature different from the color temperatures of the first fluorescence L11 and the second fluorescence L12. More specifically, the first fluorescence L11 may be, for example, light with a first color temperature. The second fluorescence L12 may be, for example, light with a second color temperature. The third fluorescence L13 may be, for example, light with a third color temperature.

Each wavelength converter 32 includes, for example, a solid member including phosphors (also referred to as a phosphor member). The phosphor member may be, for example, a pellet-like member (also referred to as a phosphor pellet) including numerous phosphor particles that each emit fluorescence in response to excitation light L0. The phosphor particles are contained in a transparent material such as a resin or glass. The wavelength converters 32 include, for example, numerous particles of different types of phosphors. The phosphor member may include a transparent board, such as a resin substrate or a glass substrate, and a phosphor pellet stacked on one another. For example, the phosphor pellet may be formed on the surface of the substrate 31 by molding with heat to directly bond each wavelength converter 32 to the surface of the substrate 31. For the phosphor pellets containing numerous phosphor particles in glass with a low melting point, for example, the phosphor pellets may be bonded to the surface of the substrate 31 when oxygen is shared between the phosphor particles and the material for the substrate 31.

The first wavelength converter 321 includes, for example, a phosphor (also referred to as a first phosphor) that emits fluorescence of a first color in response to excitation light L0. The first phosphor may be, for example, a phosphor (also referred to as a red phosphor) that emits red (R) fluorescence in response to excitation light L0. The second wavelength converter 322 includes, for example, a phosphor (also referred to as a second phosphor) that emits fluorescence of a second color in response to excitation light L0. The second phosphor may be, for example, a phosphor (also referred to as a green phosphor) that emits green (G) fluorescence in response to excitation light L0. The third wavelength converter 323 includes, for example, a phosphor (also referred to as a third phosphor) that emits fluorescence of a third color in response to excitation light L0. The third phosphor may be, for example, a phosphor (also referred to as a blue phosphor) that emits blue (B) fluorescence in response to excitation light L0.

The red phosphor is, for example, a phosphor that emits fluorescence with a peak wavelength in a range of about 620 to 750 nm in response to excitation light L0. The red phosphor material is, for example, CaAlSiN₃:Eu, Y₂O₂S:Eu, Y₂O₃:Eu, SrCaClAlSiN₃:Eu²⁺, CaAlSiN₃:Eu, or CaAlSi(ON)₃:Eu. The green phosphor is, for example, a phosphor that emits fluorescence with a peak wavelength in a range of about 495 to 570 nm in response to excitation light L0. The green phosphor material is, for example, β-SiAlON:Eu, SrSi₂(O, Cl)₂N₂:Eu, (Sr, Ba, Mg)₂SiO₄:Eu₂²⁺, ZnS:Cu, Al, or Zn₂SiO₄:Mn. The blue phosphor is, for example, a phosphor that emits fluorescence with a peak wavelength in a range of about 450 to 495 nm in response to excitation light L0. The blue phosphor material is, for example, (Ba, Sr)MgAl₁₀O₁₇:Eu, BaMgAl₁₀O₁₇:Eu, (Sr, Ca, Ba)₁₀(PO₄)₆Cl₂:Eu, or (Sr, Ba)₁₀(P0₄)₆Cl₂:Eu. The ratio of the elements in parentheses herein may be changed as appropriate without deviating from the molecular formulas. Heating may cause, for example, the green phosphor, the blue phosphor, and the red phosphor to deteriorate in this order.

In the example in FIGs. 2 and 3, the wavelength converters 32 are on the first plate surface 31f of the body 31b in the substrate 31. The wavelength converters 32 are adjacent to one another. The wavelength converters 32 may be in contact with or separate from one another. In the example in FIG. 2, a cylindrical housing 35 laterally surrounds the wavelength converters 32. The substrate 31 closes, for example, a first opening Op1 of the housing 35. For example, the housing 35 includes, opposite to the first opening Op1, a second opening Op2 closed with a lid 34. The housing 35, the substrate 31, and the lid 34 define an internal space Sp1 between the substrate 31 and the lid 34 in a hollow portion of the housing 35. The housing 35 and the lid 34 are made of, for example, a ceramic material, a resin, a metal material, or a nonmetal material. The housing 35 and the substrate 31 or the housing 35 and the lid 34 may be fixed to each other by, for example, bonding, joining, fastening, or fitting.

The light guide 4 can guide, for example, the fluorescence L1 emitted from each wavelength converter 32. For example, the light guide 4 can guide the fluorescence L1 emitted from each wavelength converter 32 toward a predetermined illumination space. More specifically, for example, the light guide 4 can guide the first fluorescence L11 emitted from the first wavelength converter 321, the second fluorescence L12 emitted from the second wavelength converter 322, and the third fluorescence L13 emitted from the third wavelength converter 323 toward a predetermined illumination space.

The light guide 4 may be, for example, an optical fiber. The optical fiber includes, for example, a core and a cladding. The cladding surrounds the core and has a lower refractive index of light than the core. In this case, for example, the fluorescence L1 emitted from each wavelength converter 32 enters a first longitudinal end (also referred to as an input end) 4e of the optical fiber. An optical element such as a lens may be attached to the input end 4e or a filter may be located on the input end 4e to reduce excitation light L0 entering the optical fiber. The optical fiber can transmit, for example, the fluorescence L1 in the longitudinal direction through the core. More specifically, the optical fiber can transmit, for example, the first fluorescence L11, the second fluorescence L12, and the third fluorescence L13 in the longitudinal direction through the core. The fluorescence L1 transmitted in the optical fiber is output through a second longitudinal end (also referred to as an output end) of the optical fiber opposite to the input end 4e. The optical fiber has, in the longitudinal direction, a length of, for example, several tens of centimeters (cm) to several tens of meters (m).

The light guide 4 can generate, for example, illumination light L2 by combining the fluorescence L1 emitted from each wavelength converter 32. More specifically, the light guide 4 can generate, for example, the illumination light L2 by combining the first fluorescence L11 emitted from the first wavelength converter 321, the second fluorescence L12 emitted from the second wavelength converter 322, and the third fluorescence L13 emitted from the third wavelength converter 323. The light guide 4 may radiate, for example, the illumination light L2 into a predetermined illumination space directly, or through an optical element such as a lens or a diffuser.

In the example in FIG. 2, the lid 34 serves as a connector for connecting the light guide 4. For example, the optical fiber as the light guide 4 is received in a through-hole 34h located in the center of the lid 34, with the input end 4e of the optical fiber serving as the light guide 4 located inside the internal space Sp1.

The control device 5 includes, for example, a controller 51 and multiple drives 52.

The controller 51 can control the other components of the control device 5 to centrally manage the operation of the control device 5. The controller 51 serves as a control circuit. The controller 51 includes at least one processor that performs control and processing for implementing various functions, as described in more detail below.

In various embodiments, the at least one processor may be implemented by a single integrated circuit (IC), or by multiple ICs connected to one another for mutual connection, discrete circuits, or both the circuits. The at least one processor may be implemented using various known techniques.

In one embodiment, the processor includes one or more circuits or units that perform one or more data computation procedures or processes by, for example, executing instructions stored in an associated memory. In another embodiment, the processor may be firmware (e.g., a discrete logic component) to perform one or more data computation procedures or processes.

In various embodiments, the processor may be one or more processors, controllers, microprocessors, microcontrollers, application-specific integrated circuits (ASICs), digital signal processors, programmable logic devices, or field programmable gate arrays, or may include any combination of these devices or components or any combination of other known devices and components to implement the functions described below.

In the present example, the controller 51 includes a central processing unit (CPU) 511 and a storage 512. The storage 512 includes a non-transitory recording medium readable by the CPU 511, such as a read-only memory (ROM) and a random-access memory (RAM). The storage 512 stores, for example, a program Pg1 for controlling the control device 5. The CPU 511 executing the program Pg1 in the storage 512 implements various functions of the controller 51. In other words, the program Pg1 is executed by the controller 51 to cause the illumination system 1 to function as the illumination system 1 in which various control operations are performed.

The configuration of the controller 51 is not limited to the above example. For example, the controller 51 may include multiple CPUs 511. The controller 51 may include at least one digital signal processor (DSP). The functions of the controller 51 may be implemented entirely or partially using hardware circuits, without using software to implement the functions. The storage 512 may also include a non-transitory computer-readable recording medium other than a ROM and a RAM. The storage 512 may include, for example, a small hard disk drive, a solid-state drive (SSD), or both the drives.

The multiple drives 52 can drive the respective light sources 21 in response to instructions from the controller 51. The drives 52 drive the light sources 21 by supplying power from the power supply 6 to the light sources 21 to cause the light sources 21 to output excitation light L0. The controller 51 can control the respective light sources 21 through the drives 52. More specifically, the controller 51 controls, for example, the supply of power from the power supply 6 to the respective light sources 21 through the multiple drives 52 to control the timing for each light source 21 to emit excitation light L0. The drives 52 include, for example, multiple electronic components including semiconductor switching elements such as transistors that can switch between supplying and not supplying power from the power supply 6 to the light sources 21. The drives 52 serve as drive circuits.

The controller 51 can cause, for example, each light source 21 to repeat emission and non-emission of excitation light L0 in constant cycles. The emission of excitation light L0 is the operation of emitting excitation light L0. The non-emission of excitation light L0 is the operation of not emitting excitation light L0. More specifically, the controller 51 causes, for example, each light source 21 to repeat one cycle of operation including emission and non-emission of excitation light L0 numerous times through the multiple drives 52. The controller 51 can change, for example, the pulse width of a signal for instructing each drive 52. This allows, for example, the ratio (also referred to as a duty ratio) of the period during which the light sources 21 emit excitation light L0 in an operation period of one cycle to be adjusted and controlled. The operation period of one cycle (also referred to as the length of one cycle) has a notably short length of, for example, about 0.5 to several milliseconds. When one cycle has, for example, a time length T and the period during which excitation light L0 is emitted from the light source 21 has a time length t, the duty ratio is the value obtained by dividing the time length t by the time length T (= t/T). The duty ratio may be expressed with, for example, a percentage of the ratio of the time length t during which excitation light L0 is emitted from the light source 21 with respect to the time length T in one cycle (= t/T × 100%).

The multiple drives 52 include, for example, a first drive 521, a second drive 522, and a third drive 523. The first drive 521 can drive, for example, the first light source 211 in response to an instruction from the controller 51. The second drive 522 can drive, for example, the second light source 212 in response to an instruction from the controller 51. The third drive 523 can drive, for example, the third light source 213 in response to an instruction from the controller 51.

For example, the controller 51 causes, through the first drive 521, the first light source 211 to repeat the cycle of emission and non-emission of excitation light L0. The controller 51 can change, for example, the pulse width of a signal for instructing the first drive 521. This allows, for example, the ratio (also referred to as a duty ratio for the first light source 211) of the period during which the first light source 211 emits excitation light L0 in the operation period of one cycle to be adjusted and controlled. In other words, the controller 51 can adjust, for example, in the operation period of one cycle, the ratio between the period during which the first light source 211 emits excitation light L0 (also referred to as a first emission period) and the period during which the first light source 211 emits no excitation light L0. For example, the ratio between the period during which the first wavelength converter 321 emits the first fluorescence L11 (also referred to as a first luminous period or a first on-period) and the period during which the first wavelength converter 321 emits no first fluorescence L11 (also referred to as a first non-luminous period or a first off-period) can thus be adjusted.

For example, the controller 51 causes, through the second drive 522, the second light source 212 to repeat the cycle of emission and non-emission of excitation light L0. The controller 51 can change, for example, the pulse width of a signal for instructing the second drive 522. This allows, for example, the ratio (also referred to as a duty ratio for the second light source 212) of the period during which the second light source 212 emits excitation light L0 in the operation period of one cycle to be adjusted and controlled. In other words, the controller 51 can adjust, for example, in the operation period of one cycle, the ratio between the period during which the second light source 212 emits excitation light L0 (also referred to as a second emission period) and the period during which the second light source 212 emits no excitation light L0. For example, the ratio between the period during which the second wavelength converter 322 emits the second fluorescence L12 (also referred to as a second luminous period or a second on-period) and the period during which the second wavelength converter 322 emits no second fluorescence L12 (also referred to as a second non-luminous period or a second off-period) can thus be adjusted.

For example, the controller 51 causes, through the third drive 523, the third light source 213 to repeat the cycle of emission and non-emission of excitation light L0. The controller 51 can change, for example, the pulse width of a signal for instructing the third drive 523. This allows, for example, the ratio (also referred to as a duty ratio for the third light source 213) of the period during which the third light source 213 emits excitation light L0 in the operation period of one cycle to be adjusted and controlled. In other words, the controller 51 can adjust, for example, in the operation period of one cycle, the ratio between the period during which the third light source 213 emits excitation light L0 (also referred to as a third emission period) and the period during which the third light source 213 emits no excitation light L0. For example, the ratio between the period during which the third wavelength converter 323 emits the third fluorescence L13 (also referred to as a third luminous period or a third on-period) and the period during which the third wavelength converter 323 emits no third fluorescence L13 (also referred to as a third non-luminous period or a third off-period) can thus be adjusted.

The controller 51 can adjust, for example, the duty ratio for each light source 21 to perform dimming and color adjustment of the illumination light L2 recognizable to the human eyes. Dimming refers to adjusting the brightness of light. Color adjustment refers to adjusting the color of light. In the first embodiment, for example, an operation period Pc1 of one cycle includes the first emission period, the second emission period, and the third emission period. In other words, for example, the controller 51 causes the first light source 211 to emit excitation light L0 toward the first wavelength converter 321, the second light source 212 to emit excitation light L0 toward the second wavelength converter 322, and the third light source 213 to emit excitation light L0 toward the third wavelength converter 323 in an operation period Pc1. The controller 51 can thus adjust the ratio between the period during which excitation light L0 is emitted and the period during which excitation light L0 is not emitted from each of the first light source 211, the second light source 212, and the third light source 213. This allows, for example, dimming and color adjustment of the illumination light L2 recognizable to the human eyes.

When the duty ratio for the first light source 211 is increased, for example, a component of the first fluorescence L11 in the illumination light L2 increases. For example, when the duty ratio for the second light source 212 is increased, a component of the second fluorescence L12 in the illumination light L2 increases. For example, when the duty ratio for the third light source 213 is increased, a component of the third fluorescence L13 in the illumination light L2 increases. For example, when the duty ratio for the first light source 211 is decreased, the component of the first fluorescence L11 in the illumination light L2 decreases. For example, when the duty ratio for the second light source 212 is decreased, the component of the second fluorescence L12 in the illumination light L2 decreases. For example, when the duty ratio for the third light source 213 is decreased, the component of the third fluorescence L13 in the illumination light L2 decreases. The controller 51 can individually adjust, for example, the duty ratio for each light source 21 to perform dimming and color adjustment of the illumination light L2. This control method including dimming and color adjustment by adjusting the duty ratio for each light source 21 is also referred to as pulse width modulation (PWM).

### 1-2. Control Example of Illumination System

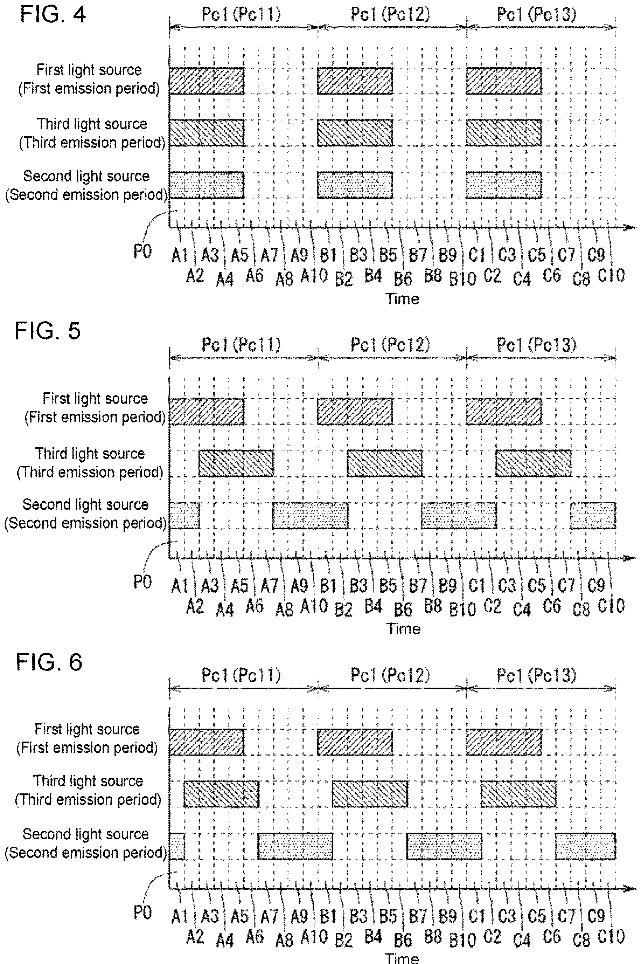

FIG. 4 is a graph showing periods during which each of the light sources 21 emits excitation light L0 in a reference example. FIGs. 5 to 18 are graphs showing example periods during which each of the light sources 21 emits excitation light L0 in the illumination system 1 according to the first embodiment. In other words, FIGs. 5 to 18 are graphs each showing an example method for controlling the illumination system 1 according to the first embodiment.

The reference example in FIG. 4 and the examples in FIGs. 5 to 18 each show, with the horizontal axis indicating time, periods during which each of the light sources 21 emits excitation light L0 in three continuous operation periods Pc1 repeated multiple times. The three continuous operation periods Pc1 include an operation period (also referred to as a first cycle operation period) Pc11 of a first cycle, an operation period (also referred to as a second cycle operation period) Pc12 of a second cycle, and an operation period (also referred to as a third cycle operation period) Pc13 of a third cycle. In these examples, an operation period Pc1 is from a timing (also referred to as a first start timing) at which the first light source 211 starts irradiating the first wavelength converter 321 (also referred to as first irradiation) with excitation light L0 to a timing (also referred to as a second start timing) at which the first light source 211 starts irradiating the first wavelength converter 321 (also referred to as second irradiation) subsequently to the first irradiation of excitation light L0 toward the first wavelength converter 321. The length of an operation period Pc1 is the interval between the timings at which the first light source 211 starts irradiating the first wavelength converter 321 with excitation light L0. In the first embodiment, the first light source 211 starts irradiating the first wavelength converter 321 with excitation light L0, the second light source 212 starts irradiating the second wavelength converter 322 with excitation light L0, and the third light source 213 starts irradiating the third wavelength converter 323 with excitation light L0 at the same intervals between the timings.

In the reference example in FIG. 4 and in the examples in FIGs. 5 to 18, an operation period Pc1 includes multiple (e.g., ten) unit periods P0 that are continuous in time. Each unit period P0 has a predetermined length of, for example, about 0.1 milliseconds. An operation period Pc1 has a predetermined length of, for example, about one millisecond.

More specifically, for example, the first cycle operation period Pc11 includes ten continuous unit periods P0 including a first unit period (also referred to as a first-A unit period) A1 to a tenth unit period (also referred to as a tenth-A unit period) A10. The first-A unit period A1 to the tenth-A unit period A10 include a first-A unit period A1, a second unit period (also referred to as a second-A unit period) A2, a third unit period (also referred to as a third-A unit period) A3, a fourth unit period (also referred to as a fourth-A unit period) A4, a fifth unit period (also referred to as a fifth-A unit period) A5, a sixth unit period (also referred to as a sixth-A unit period) A6, a seventh unit period (also referred to as a seventh-A unit period) A7, an eighth unit period (also referred to as an eighth-A unit period) A8, a ninth unit period (also referred to as a ninth-A unit period) A9, and a tenth-A unit period A10.

For example, the second cycle operation period Pc12 includes ten continuous unit periods P0 including a first unit period (also referred to as a first-B unit period) B1 to a tenth unit period (also referred to as a tenth-B unit period) B10. The first-B unit period B1 to the tenth-B unit period B 10 include a first-B unit period B1, a second unit period (also referred to as a second-B unit period) B2, a third unit period (also referred to as a third-B unit period) B3, a fourth unit period (also referred to as a fourth-B unit period) B4, a fifth unit period (also referred to as a fifth-B unit period) B5, a sixth unit period (also referred to as a sixth-B unit period) B6, a seventh unit period (also referred to as a seventh-B unit period) B7, an eighth unit period (also referred to as an eighth-B unit period) B8, a ninth unit period (also referred to as a ninth-B unit period) B9, and a tenth-B unit period B 10.

For example, the third cycle operation period Pc13 includes ten continuous unit periods P0 including a first unit period (also referred to as a first-C unit period) C1 to a tenth unit period (also referred to as a tenth-C unit period) C10. The first-C unit period C1 to the tenth-C unit period C10 include a first-C unit period C1, a second unit period (also referred to as a second-C unit period) C2, a third unit period (also referred to as a third-C unit period) C3, a fourth unit period (also referred to as a fourth-C unit period) C4, a fifth unit period (also referred to as a fifth-C unit period) C5, a sixth unit period (also referred to as a sixth-C unit period) C6, a seventh unit period (also referred to as a seventh-C unit period) C7, an eighth unit period (also referred to as an eighth-C unit period) C8, a ninth unit period (also referred to as a ninth-C unit period) C9, and a tenth-C unit period C10.

For example, a period from the start of the first-A unit period A1 to the start of the first-B unit period B 1, and a period from the start of the first-B unit period B1 to the start of the first-C unit period C1 are each an operation period Pc1. The number of unit periods P0 included in an operation period Pc1 may be, for example, any number greater than or equal to two in place of ten.

In FIGs. 4 to 18, the period (the first emission period) during which the first light source 211 emits excitation light L0 is indicated by a square hatched with diagonal lines rising to the upper right. The period (the third emission period) during which the third light source 213 emits excitation light L0 is indicated by a square hatched with diagonal lines rising to the upper left. The period (the second emission period) during which the second light source 212 emits excitation light L0 is indicated by a square hatched with dots. In the examples in FIGs. 4 to 18, an operation period Pc1 includes the first emission period during which the first light source 211 emits excitation light L0 toward the first wavelength converter 321, the second emission period during which the second light source 212 emits excitation light L0 toward the second wavelength converter 322, and the third emission period during which the third light source 213 emits excitation light L0 toward the third wavelength converter 323.

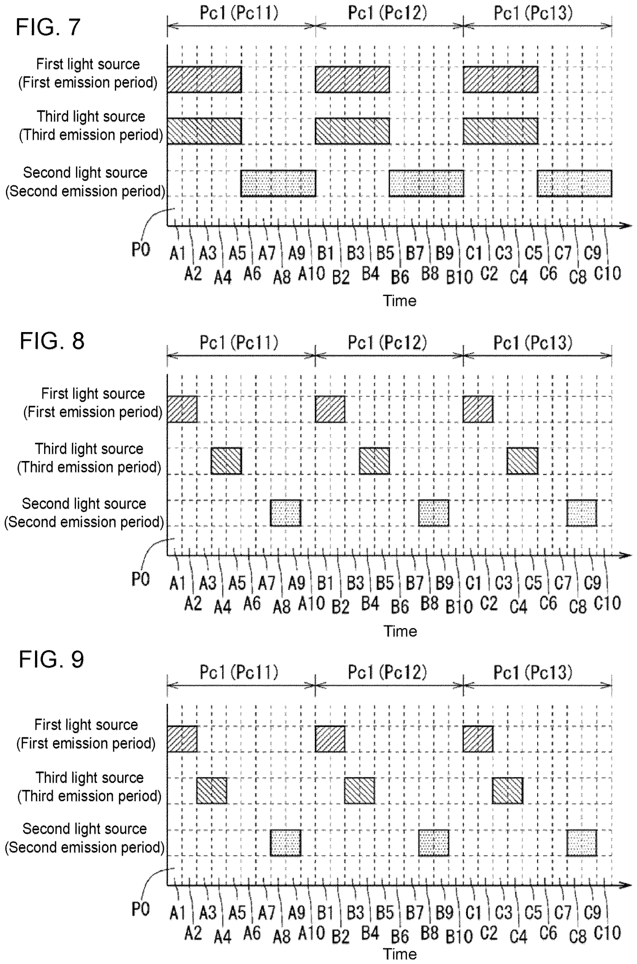

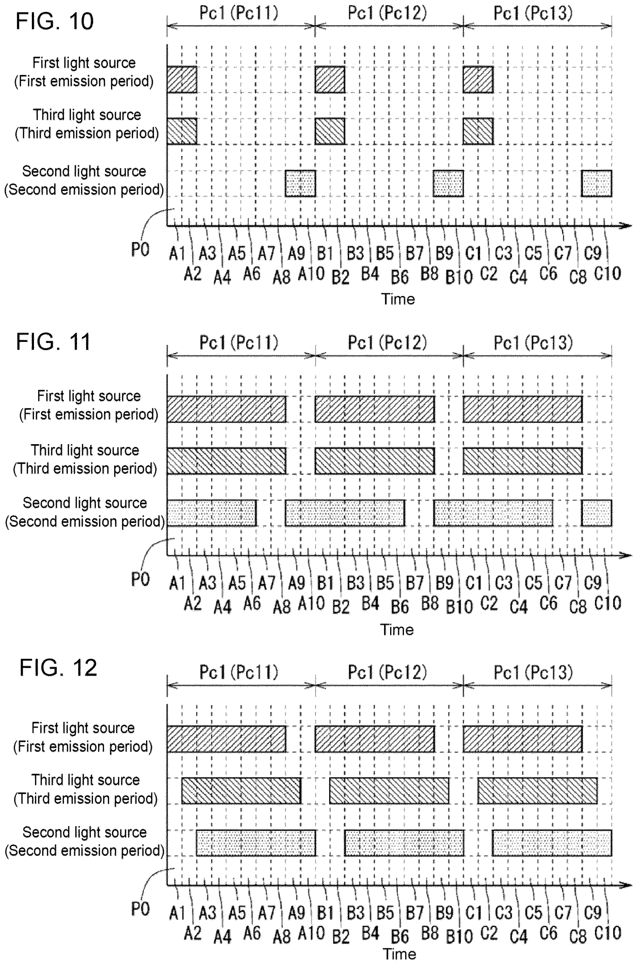

In the reference example in FIG. 4 and in the examples in FIGs. 5 to 12, the first emission period, the second emission period, and the third emission period have the same length in an operation period Pc1. More specifically, the duty ratio for each of the first light source 211, the second light source 212, and the third light source 213 is 0.5 in the reference example in FIG. 4 and in the examples in FIGs. 5 to 7. In the examples in FIGs. 8 to 10, the duty ratio for each of the first light source 211, the second light source 212, and the third light source 213 is 0.2 as an example of a value less than 0.5. A value less than 0.5 as the duty ratio may be, for example, greater than 0 and less than 0.5, such as 0.1, 0.3, or 0.4. In the examples in FIGs. 11 and 12, the duty ratio for each of the first light source 211, the second light source 212, and the third light source 213 is 0.8 as an example of a value greater than 0.5. A value greater than 0.5 as the duty ratio may be, for example, greater than 0.5 and less than 1, such as 0.6, 0.7, or 0.9.

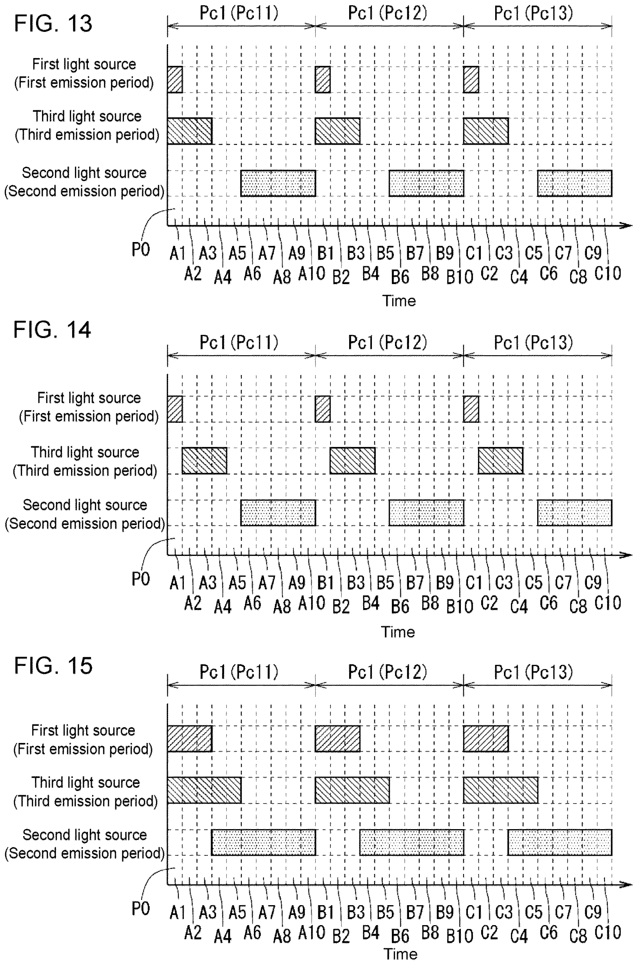

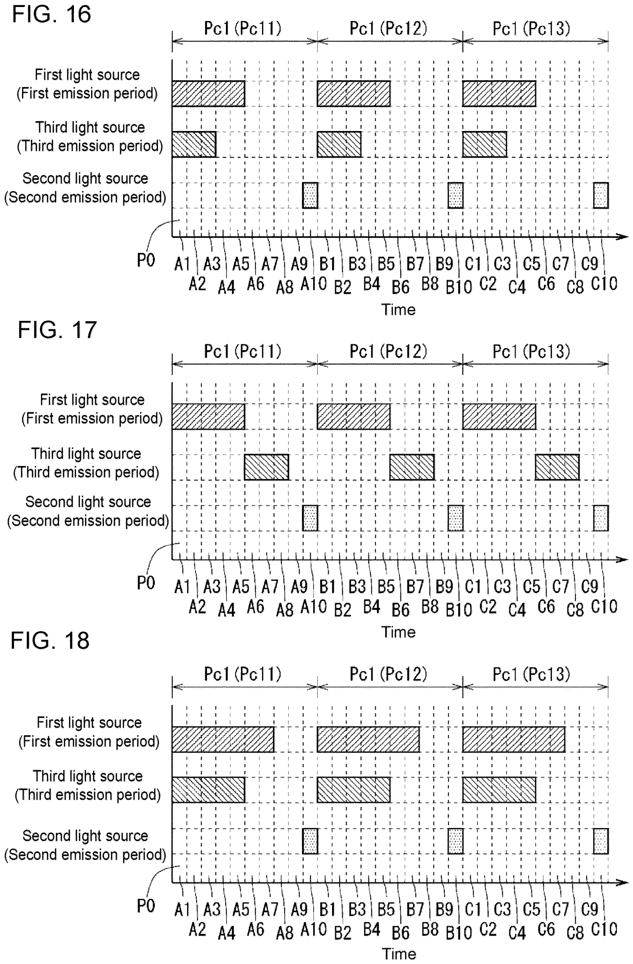

In the examples in FIGs. 13 to 18, the first emission period, the second emission period, and the third emission period have different lengths in an operation period Pc1. More specifically, in the examples in FIGs. 13 and 14, the duty ratio for the first light source 211 is 0.1, the duty ratio for the third light source 213 is 0.3, and the duty ratio for the second light source 212 is 0.5. In the example in FIG. 15, the duty ratio for the first light source 211 is 0.3, the duty ratio for the third light source 213 is 0.5, and the duty ratio for the second light source 212 is 0.7. In the examples in FIGs. 16 and 17, the duty ratio for the first light source 211 is 0.5, the duty ratio for the third light source 213 is 0.3, and the duty ratio for the second light source 212 is 0.1. In the example in FIG. 18, the duty ratio for the first light source 211 is 0.7, the duty ratio for the third light source 213 is 0.5, and the duty ratio for the second light source 212 is 0.1.

In the reference example in FIG. 4, the first light source 211, the second light source 212, and the third light source 213 repeat emission and non-emission of light simultaneously. In the first cycle operation period Pc11, each of the first light source 211, the second light source 212, and the third light source 213 emits excitation light L0 from the first-A unit period A1 to the fifth-A unit period A5. In the second cycle operation period Pc12, each of the first light source 211, the second light source 212, and the third light source 213 emits excitation light L0 from the first-B unit period B1 to the fifth-B unit period B5. In the third cycle operation period Pc13, each of the first light source 211, the second light source 212, and the third light source 213 emits excitation light L0 from the first-C unit period C1 to the fifth-C unit period C5.

Under the control in the reference example in FIG. 4, the first wavelength converter 321, the second wavelength converter 322, and the third wavelength converter 323 are heated simultaneously when irradiated by each of the first light source 211, the second light source 212, and the third light source 213 with excitation light L0. In this case, for example, the substrate 31 functioning as a heat sink cools all three wavelength converters 32 simultaneously, and thus the three wavelength converters 32 are cooled less easily. This causes, for example, the phosphors in the three wavelength converters 32 to deteriorate easily under heat.

In contrast, as illustrated in the examples in FIGs. 5 to 18, for example, the first emission period and the second emission period may be shifted from each other in an operation period Pc1. In this case, the controller 51 causes each light source 21 to repeat emission and non-emission of excitation light L0 in constant cycles. The controller 51 causes, in an operation period Pc1, the second light source 212 to emit no excitation light L0 toward the second wavelength converter 322 for at least a portion of the first emission period during which the first light source 211 emits excitation light L0 toward the first wavelength converter 321. The controller 51 causes, in an operation period Pc1 of one cycle, the first light source 211 to emit no excitation light L0 toward the first wavelength converter 321 for at least a portion of the second emission period during which the second light source 212 emits excitation light L0 toward the second wavelength converter 322.

In other words, as illustrated in the examples in FIGs. 5 to 18, for example, the control method for the illumination system 1 includes a step performed by the controller 51 to cause each light source 21 to repeat emission and non-emission of excitation light L0 in constant cycles. In this step, the controller 51 causes, in an operation period Pc1, the second light source 212 to emit no excitation light L0 toward the second wavelength converter 322 for at least a portion of the first emission period and causes the first light source 211 to emit no excitation light L0 toward the first wavelength converter 321 for at least a portion of the second emission period.

This control shortens, for example, the period during which the first wavelength converter 321 and the second wavelength converter 322 are heated simultaneously. The temperatures of the first wavelength converter 321 and the second wavelength converter 322 are thus less likely to increase. This reduces deterioration of the phosphors in the first wavelength converter 321 and the second wavelength converter 322. Thus, the illumination system 1 that can adjust the light color may reduce, for example, deterioration of the phosphors.

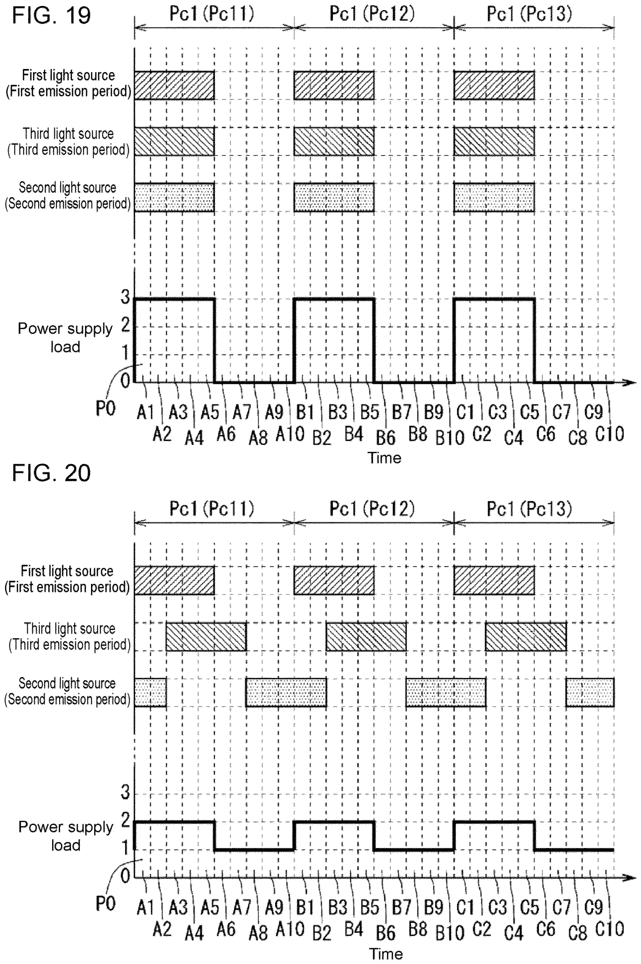

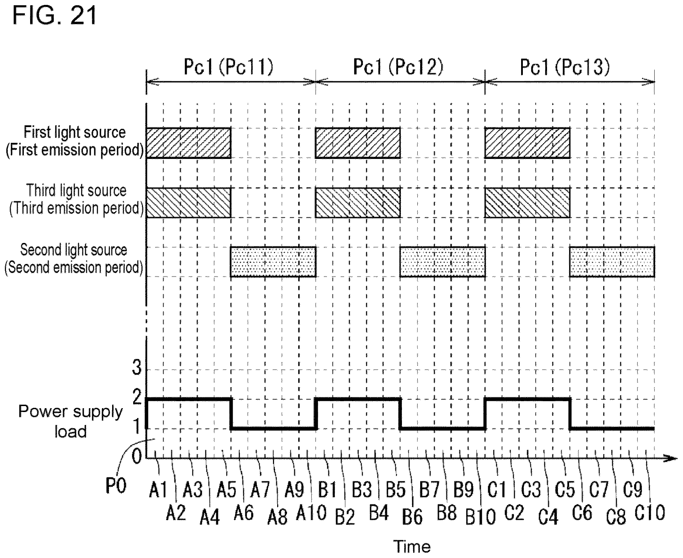

FIG. 19 is a graph showing the relationship between the periods during which each of the light sources 21 emits excitation light L0 and changes in a load (also referred to as a power supply load) connected to a power supply 6 in a reference example. FIG. 19 shows, with a thick line, changes in the power supply load under the control in the reference example in FIG. 4. FIGs. 20 and 21 are each a graph showing an example relationship between the periods during which each of the light sources 21 emits excitation light L0 and the changes in the load (power supply load) connected to the power supply 6. FIG. 20 shows, with a thick line, changes in the power supply load under the control in the example in FIG. 5. FIG. 21 shows, with a thick line, changes in the power supply load under the control in the example in FIG. 7. In FIGs. 19 to 21, the horizontal axis indicates time, and the vertical axis for the power supply load schematically indicates the magnitude of the power supply load. The power supply load may be, for example, a current supplied to or power provided to the light sources 21.

As illustrated in FIG. 19, when the first light source 211, the second light source 212, and the third light source 213 simultaneously repeat emission and non-emission of light, instantaneous changes in the power supply load are large. More specifically, in the reference example in FIG. 19, the power supply load instantaneously changes from 0 to 3 and from 3 to 0. To withstand such instantaneous changes in the power supply load, a power supply with high-speed responsiveness, high durability, and high performance (also referred to as a high-speed high-performance power supply) may be used. In contrast, as illustrated in FIGs. 20 and 21, for example, the first emission period and the second emission period shifted from each other or the first emission period, the second emission period, and the third emission period shifted from one another may reduce instantaneous changes in the power supply load. More specifically, as illustrated in the examples in FIGs. 20 and 21, the instantaneous changes in the power supply load are relatively small, changing from 1 to 2 and from 2 to 1. As described above and as illustrated in the examples in FIGs. 5 to 18, for example, the first emission period and the second emission period may be shifted from each other in an operation period Pc1 to reduce the instantaneous changes in the power supply load. This eliminates a high-speed high-performance power supply and reduces deterioration of the power supply 6. This structure can thus improve, for example, the reliability of the power supply 6 and the illumination system 1 at low cost.

For example, as illustrated in FIGs. 5, 6, 8, 9, 12, 14, and 17, the first emission period, the second emission period, and the third emission period may be shifted from one another in an operation period Pc1. In this case, the controller 51 causes, in an operation period Pc1, the third light source 213 to emit no excitation light L0 toward the third wavelength converter 323 for at least a portion of the first emission period and causes the first light source 211 to emit no excitation light L0 toward the first wavelength converter 321 for at least a portion of the third emission period. The controller 51 causes, in an operation period Pc1, the third light source 213 to emit no excitation light L0 toward the third wavelength converter 323 for at least a portion of the second emission period and causes the second light source 212 to emit no excitation light L0 toward the second wavelength converter 322 for at least a portion of the third emission period.

This control reduces, for example, the likelihood that excitation light L0 irradiates the first wavelength converter 321, the second wavelength converter 322, and the third wavelength converter 323 simultaneously. The temperatures of the first wavelength converter 321, the second wavelength converter 322, and the third wavelength converter 323 are thus less likely to increase. This reduces deterioration of the phosphors in the first wavelength converter 321, the second wavelength converter 322, and the third wavelength converter 323. Thus, the illumination system 1 that can adjust the light color may reduce, for example, deterioration of the phosphors.

As illustrated in the examples in FIGs. 8, 9, 14, and 17, the first emission period, the second emission period, and the third emission period may not overlap one another. In this case, the controller 51 causes, in the first emission period, the second light source 212 and the third light source 213 to emit no excitation light L0 toward the second wavelength converter 322 and the third wavelength converter 323. The controller 51 causes, in the third emission period, the first light source 211 and the second light source 212 to emit no excitation light L0 toward the first wavelength converter 321 and the second wavelength converter 322. The controller 51 causes, in the second emission period, the first light source 211 and the third light source 213 to emit no excitation light L0 toward the first wavelength converter 321 and the third wavelength converter 323.

This control allows, for example, no excitation light L0 to irradiate two or more wavelength converters 32 among the first wavelength converter 321, the second wavelength converter 322, and the third wavelength converter 323. The temperatures of the first wavelength converter 321, the second wavelength converter 322, and the third wavelength converter 323 are thus less likely to increase. This reduces deterioration of the phosphors in the first wavelength converter 321, the second wavelength converter 322, and the third wavelength converter 323. Thus, the illumination system 1 that can adjust the light color may reduce, for example, deterioration of the phosphors.

As illustrated in the example in FIG. 8, the first emission period and the third emission period may be separate from each other, the third emission period and the second emission period may be separate from each other, and the second emission period and the third emission period may be separate from each other. In this case, the controller 51 causes, in an operation period Pc1, each light source 21 to emit no excitation light L0 to the corresponding wavelength converter 32 in the periods between the first emission period and the third emission period, between the third emission period and the second emission period, and between the second emission period and the subsequent period. The light sources 21 emit, in an operation period Pc1, no excitation light L0 in the periods (non-emission periods) between the first emission period and the third emission period, between the third emission period and the second emission period, and between the second emission period and the subsequent period. The period between the first emission period and the third emission period in an operation period Pc1 may be referred to as a first non-emission period. The period between the third emission period and the second emission period in an operation period Pc1 may be referred to as a second non-emission period. The period between the second emission period and the subsequent period in an operation period Pc1 may be referred to as a third non-emission period. The controller 51 thus causes, in the first non-emission period, the second non-emission period, and the third non-emission period in an operation period Pc1, the first light source 211, the second light source 212, and the third light source 213 to emit no excitation light L0 to the first wavelength converter 321, the second wavelength converter 322, and the third wavelength converter 323. This control reduces the likelihood that, for example, the temperatures of the first wavelength converter 321, the second wavelength converter 322, and the third wavelength converter 323 increase. The first emission period, the second emission period, and the third emission period may have, for example, different lengths in an operation period Pc1.

As illustrated in the example in FIG. 8, the second non-emission period may be longer than both the first non-emission period and the third non-emission period. In this case, for example, irradiation of excitation light L0 may start toward the second wavelength converter 322 after the irradiation of excitation light L0 toward the third wavelength converter 323 is complete with the substrate 31 as a heat sink being cooled. The temperature of the second wavelength converter 322 is thus, for example, less likely to increase. For example, the illumination system 1 that can adjust the light color can reduce deterioration of phosphors when phosphors in the second wavelength converter 322 are more likely to deteriorate with heat than phosphors in the first wavelength converter 321 and the third wavelength converter 323. The first emission period, the second emission period, and the third emission period may have, for example, different lengths in an operation period Pc1.

The control in the example in FIG. 8 may be replaced with the control in the example in FIG. 9. In this case, the controller 51 causes no first non-emission period between the first emission period and the third emission period in an operation period Pc1. The controller 51 causes, in an operation period Pc1, the first light source 211, the second light source 212, and the third light source 213 to emit no excitation light L0 toward the first wavelength converter 321, the second wavelength converter 322, and the third wavelength converter 323 in both the second non-emission period and the third non-emission period. In this example, the second non-emission period is longer than the third non-emission period.

This control allows, for example, the substrate 31 as a heat sink to be easily cooled before the irradiation of excitation light L0 starts toward the second wavelength converter 322. Irradiation of excitation light L0 starts toward the first wavelength converter 321 after the irradiation of excitation light L0 toward the second wavelength converter 322 is complete with the substrate 31 being cooled for a short time. The second wavelength converter 322 is thus less likely to be heated through the substrate 31. For example, the illumination system 1 that can adjust the light color can reduce deterioration of phosphors when phosphors in the second wavelength converter 322 are more likely to deteriorate with heat than phosphors in the first wavelength converter 321 and the third wavelength converter 323. The first emission period, the second emission period, and the third emission period may have, for example, different lengths in an operation period Pc1.

In other words, as illustrated in the examples in FIGs. 5 to 18, for example, at least a part of the second emission period may not overlap both the first emission period and the third emission period in an operation period Pc1. In this case, the controller 51 causes, in an operation period Pc1, the first light source 211 and the third light source 213 to emit no excitation light L0 toward the first wavelength converter 321 and the third wavelength converter 323 for at least a portion of the second emission period.

The temperature of the second wavelength converter 322 under this control is thus, for example, less likely to increase. For example, the illumination system 1 that can adjust the light color can reduce deterioration of phosphors when phosphors in the second wavelength converter 322 are more likely to deteriorate with heat than phosphors in the first wavelength converter 321 and the third wavelength converter 323.

As illustrated in the examples in FIGs. 5 to 7, 10 to 13, 15, 16, and 18, for example, the first emission period and the third emission period may at least partially overlap each other in an operation period Pc1. In this case, the controller 51 causes, in an operation period Pc1, the third light source 213 to emit excitation light L0 toward the third wavelength converter 323 for at least a portion of the first emission period.

This control extends, for example, the period during which no excitation light L0 is irradiated toward both the first wavelength converter 321 and the third wavelength converter 323 in the second emission period during which excitation light L0 is irradiated toward the second wavelength converter 322. The temperature of the second wavelength converter 322 is thus, for example, less likely to increase. For example, the illumination system 1 that can adjust the light color can reduce deterioration of phosphors when phosphors in the second wavelength converter 322 are more likely to deteriorate with heat than phosphors in the first wavelength converter 321 and the third wavelength converter 323.

As illustrated in the examples in FIGs. 7, 10, 11, 13, 15, 16, and 18, for example, in an operation period Pc1, the first emission period may include the third emission period, or the third emission period may include the first emission period. In this case, the controller 51 may cause, in an operation period Pc1, the third light source 213 to start or end the emission of excitation light L0 toward the third wavelength converter 323 in the first emission period, or cause the first light source 211 to start or end the emission of excitation light L0 toward the first wavelength converter 321 in the third emission period. The controller 51 may also cause the first light source 211 and the third light source 213 to simultaneously start or end the emission of excitation light L0 in an operation period Pc1.

This control may further extend, for example, the period during which no excitation light L0 is irradiated toward both the first wavelength converter 321 and the third wavelength converter 323 in the second emission period during which excitation light L0 is irradiated toward the second wavelength converter 322. The temperature of the second wavelength converter 322 is thus, for example, less likely to increase. For example, the illumination system 1 that can adjust the light color can reduce deterioration of phosphors when phosphors in the second wavelength converter 322 are more likely to deteriorate with heat than phosphors in the first wavelength converter 321 and the third wavelength converter 323.

As illustrated in the examples in FIGs. 7, 10, 11, 13, 15, 16, and 18, for example, an operation period Pc1 may not include a non-emission period after the second emission period. In this case, the controller 51 causes no period (no non-emission period) during which the first light source 211, the second light source 212, and the third light source 213 emit no excitation light L0 toward the first wavelength converter 321, the second wavelength converter 322, and the third wavelength converter 323 after the second emission period in an operation period Pc1.

This control may extend, for example, the period during which no excitation light L0 is irradiated toward both the first wavelength converter 321 and the third wavelength converter 323 in the second emission period during which excitation light L0 is irradiated toward the second wavelength converter 322. The temperature of the second wavelength converter 322 is thus, for example, less likely to increase. For example, the illumination system 1 that can adjust the light color can reduce deterioration of phosphors when phosphors in the second wavelength converter 322 are more likely to deteriorate with heat than phosphors in the first wavelength converter 321 and the third wavelength converter 323.

As illustrated in the examples in FIGs. 7, 10, 13, 16, and 18, for example, the second emission period may not overlap both the first emission period and the third emission period in an operation period Pc1. In this case, the controller 51 causes, in an operation period Pc1, the first light source 211 and the third light source 213 to emit no excitation light L0 toward the first wavelength converter 321 and the third wavelength converter 323 in the second emission period.

The temperature of the second wavelength converter 322 under this control is thus, for example, less likely to increase further. For example, the illumination system 1 that can adjust the light color can further reduce deterioration of phosphors when phosphors in the second wavelength converter 322 are more likely to deteriorate with heat than phosphors in the first wavelength converter 321 and the third wavelength converter 323.

As illustrated in the examples in FIGs. 10, 13, 16, and 18, for example, an operation period Pc1 may include a non-emission period between the first emission period and the second emission period and between the third emission period and the second emission period. In this case, the controller 51 causes, in an operation period Pc1, the first light source 211, the second light source 212, and the third light source 213 to emit no excitation light L0 toward the first wavelength converter 321, the second wavelength converter 322, and the third wavelength converter 323 in a period (non-emission period) between the first emission period and the second emission period and between the third emission period and the second emission period.

This control allows, for example, the substrate 31 to be cooled well before the irradiation of excitation light L0 toward the second wavelength converter 322. The temperature of the second wavelength converter 322 is thus, for example, less likely to increase. For example, the illumination system 1 that can adjust the light color can further reduce deterioration of phosphors when phosphors in the second wavelength converter 322 are more likely to deteriorate with heat than phosphors in the first wavelength converter 321 and the third wavelength converter 323.

The control performed by the controller 51 in the examples in FIGs. 5 to 18 will now be described in detail.

In the example in FIG. 5, the controller 51 causes, in an operation period Pc1, the first light source 211 to emit excitation light L0 toward the first wavelength converter 321 in the first to fifth unit periods P0, the third light source 213 to emit excitation light L0 toward the third wavelength converter 323 in the third to seventh unit periods P0, and the second light source 212 to emit excitation light L0 toward the second wavelength converter 322 in the first, the second, and the eighth to tenth unit periods P0. Under the control in the example in FIG. 5, for example, irradiation of excitation light L0 may start toward the second wavelength converter 322 after the irradiation of excitation light L0 toward the first wavelength converter 321 is complete with the substrate 31 being substantially cooled. The temperature of the second wavelength converter 322 is thus, for example, less likely to increase, possibly reducing deterioration of the phosphors in the second wavelength converter 322.

In the example in FIG. 6, the controller 51 causes, in an operation period Pc1, the first light source 211 to emit excitation light L0 toward the first wavelength converter 321 in the first to fifth unit periods P0, the third light source 213 to emit excitation light L0 toward the third wavelength converter 323 in the second to sixth unit periods P0, and the second light source 212 to emit excitation light L0 toward the second wavelength converter 322 in the first and the seventh to tenth unit periods P0. Under the control in the example in FIG. 6, irradiation of excitation light L0 starts toward the second wavelength converter 322 after the irradiation of excitation light L0 toward the first wavelength converter 321 is complete with the substrate 31 being cooled for a short time, and no excitation light L0 is irradiated toward the first wavelength converter 321 and the third wavelength converter 323 in a most portion of the second emission period during which excitation light L0 is irradiated toward the second wavelength converter 322. The temperature of the second wavelength converter 322 is thus, for example, less likely to increase, possibly reducing deterioration of the phosphors in the second wavelength converter 322.

In the example in FIG. 7, the controller 51 causes, in an operation period Pc1, the first light source 211 to emit excitation light L0 toward the first wavelength converter 321 and the third light source 213 to emit excitation light L0 toward the third wavelength converter 323 in the first to fifth unit periods P0, and the second light source 212 to emit excitation light L0 toward the second wavelength converter 322 in the sixth to tenth unit periods P0. Under the control in the example in FIG. 7, for example, the first emission period and the third emission period overlap each other, and the second emission period does not overlap either the first emission period or the third emission period. The temperature of the second wavelength converter 322 is thus, for example, less likely to increase, possibly reducing deterioration of the phosphors in the second wavelength converter 322.

In the example in FIG. 8, the controller 51 causes, in an operation period Pc1, the first light source 211 to emit excitation light L0 toward the first wavelength converter 321 in the first and the second unit periods P0, the third light source 213 to emit excitation light L0 toward the third wavelength converter 323 in the fourth and the fifth unit periods P0, and the second light source 212 to emit excitation light L0 toward the second wavelength converter 322 in the eighth and the ninth unit periods P0. Under the control in the example in FIG. 8, the non-emission period in two unit periods P0 between the third emission period and the second emission period is longer than the non-emission period in one unit period P0 between the first emission period and the third emission period in an operation period Pc1. The temperature of each of the first wavelength converter 321, the second wavelength converter 322, and the third wavelength converter 323 is thus, for example, less likely to increase. Irradiation of excitation light L0 may thus start toward the second wavelength converter 322 after the irradiation of excitation light L0 toward the third wavelength converter 323 is complete with the substrate 31 being cooled. The temperature of the second wavelength converter 322 is thus, for example, less likely to increase, possibly reducing deterioration of the phosphors in the second wavelength converter 322.

In the example in FIG. 9, the controller 51 causes, in an operation period Pc1, the first light source 211 to emit excitation light L0 toward the first wavelength converter 321 in the first and the second unit periods P0, the third light source 213 to emit excitation light L0 toward the third wavelength converter 323 in the third and the fourth unit periods P0, and the second light source 212 to emit excitation light L0 toward the second wavelength converter 322 in the eighth and the ninth unit periods P0. Under the control in the example in FIG. 9, the non-emission period in three unit periods P0 between the third emission period and the second emission period is longer than the non-emission period in one unit period P0 after the second emission period in an operation period Pc1. Irradiation of excitation light L0 may thus start toward the second wavelength converter 322 after the irradiation of excitation light L0 toward the third wavelength converter 323 is complete with the substrate 31 being cooled. The temperature of the second wavelength converter 322 is thus, for example, less likely to increase, possibly reducing deterioration of the phosphors in the second wavelength converter 322.

In the example in FIG. 10, the controller 51 causes, in an operation period Pc1, the first light source 211 to emit excitation light L0 toward the first wavelength converter 321 and the third light source 213 to emit excitation light L0 toward the third wavelength converter 323 in the first and the second unit periods P0, and the second light source 212 to emit excitation light L0 toward the second wavelength converter 322 in the ninth and the tenth unit periods P0. Under the control in the example in FIG. 10, irradiation of excitation light L0 may start toward the second wavelength converter 322, with the substrate 31 being cooled well, in a particularly long non-emission period in six unit periods P0 after the first emission period and the third emission period fully overlapping each other and before the second emission period. The temperature of the second wavelength converter 322 is thus, for example, less likely to increase, possibly reducing deterioration of the phosphors in the second wavelength converter 322.

In the example in FIG. 11, the controller 51 causes, in an operation period Pc1, the first light source 211 to emit excitation light L0 toward the first wavelength converter 321 and the third light source 213 to emit excitation light L0 toward the third wavelength converter 323 in the first to eighth unit periods P0, and the second light source 212 to emit excitation light L0 toward the second wavelength converter 322 in the first to sixth, the ninth, and the tenth unit periods P0. Under the control in the example in FIG. 11, for example, the first emission period and the third emission period may overlap each other in the second emission period for a shorter time. The temperature of the second wavelength converter 322 is thus, for example, less likely to increase, possibly reducing deterioration of the phosphors in the second wavelength converter 322.

In the example in FIG. 12, the controller 51 causes, in an operation period Pc1, the first light source 211 to emit excitation light L0 toward the first wavelength converter 321 in the first to eighth unit periods P0, the third light source 213 to emit excitation light L0 toward the third wavelength converter 323 in the second to ninth unit periods P0, and the second light source 212 to emit excitation light L0 toward the second wavelength converter 322 in the third to tenth unit periods P0. Under the control in the example in FIG. 12, the first emission period, the second emission period, and the third emission period have, for example, start and end timings different from one another. This reduces, for example, instantaneous changes in the power supply load. The power supply 6 is thus less likely to deteriorate.

In the example in FIG. 13, the controller 51 causes, in an operation period Pc1, the first light source 211 to emit excitation light L0 toward the first wavelength converter 321 in the first unit period P0, the third light source 213 to emit excitation light L0 toward the third wavelength converter 323 in the first to third unit periods P0, and the second light source 212 to emit excitation light L0 toward the second wavelength converter 322 in the sixth to tenth unit periods P0. Under the control in the example in FIG. 13, irradiation of excitation light L0 may start toward the second wavelength converter 322, with the substrate 31 being cooled, in a particularly long non-emission period in two unit periods P0 between the third emission period including the first emission period and the second emission period. The temperature of the second wavelength converter 322 is thus, for example, less likely to increase, possibly reducing deterioration of the phosphors in the second wavelength converter 322.

In the example in FIG. 14, the controller 51 causes, in an operation period Pc1, the first light source 211 to emit excitation light L0 toward the first wavelength converter 321 in the first unit period P0, the third light source 213 to emit excitation light L0 toward the third wavelength converter 323 in the second to fourth unit periods P0, and the second light source 212 to emit excitation light L0 toward the second wavelength converter 322 in the sixth to tenth unit periods P0. Under the control in the example in FIG. 14, the first emission period, the third emission period, and the second emission period do not overlap one another with an operation period Pc1 including a non-emission period in one unit period P0 between the third emission period and the second emission period. The temperature of each of the first wavelength converter 321, the second wavelength converter 322, and the third wavelength converter 323 is thus, for example, less likely to increase. Irradiation of excitation light L0 may thus start toward the second wavelength converter 322 after the irradiation of excitation light L0 toward the third wavelength converter 323 is complete with the substrate 31 being cooled. The temperature of the second wavelength converter 322 is thus, for example, less likely to increase, possibly reducing deterioration of the phosphors in the second wavelength converter 322.

In the example in FIG. 15, the controller 51 causes, in an operation period Pc1, the first light source 211 to emit excitation light L0 toward the first wavelength converter 321 in the first to third unit periods P0, the third light source 213 to emit excitation light L0 toward the third wavelength converter 323 in the first to fifth unit periods P0, and the second light source 212 to emit excitation light L0 toward the second wavelength converter 322 in the fourth to tenth unit periods P0. Under the control in the example in FIG. 15, for example, the third emission period includes the first emission period with no non-emission period after the second emission period in an operation period Pc1. This control may extend, for example, the period during which no excitation light L0 is irradiation toward both the first wavelength converter 321 and the third wavelength converter 323 in the second emission period. The temperature of the second wavelength converter 322 is thus, for example, less likely to increase, possibly reducing deterioration of the phosphors in the second wavelength converter 322.

In the example in FIG. 16, the controller 51 causes, in an operation period Pc1, the first light source 211 to emit excitation light L0 toward the first wavelength converter 321 in the first to fifth unit periods P0, the third light source 213 to emit excitation light L0 toward the third wavelength converter 323 in the first to third unit periods P0, and the second light source 212 to emit excitation light L0 toward the second wavelength converter 322 in the tenth unit period P0. Under the control in the example in FIG. 16, for example, the second emission period does not overlap both the first emission period and the third emission period, and irradiation of excitation light L0 may start toward the second wavelength converter 322, with the substrate 31 being cooled well, in a particularly long non-emission period in four unit periods P0 between the first emission period including the third emission period and the second emission period. The temperature of the second wavelength converter 322 is thus, for example, less likely to increase, possibly reducing deterioration of the phosphors in the second wavelength converter 322.

In the example in FIG. 17, the controller 51 causes, in an operation period Pc1, the first light source 211 to emit excitation light L0 toward the first wavelength converter 321 in the first to fifth unit periods P0, the third light source 213 to emit excitation light L0 toward the third wavelength converter 323 in the sixth to eighth unit periods P0, and the second light source 212 to emit excitation light L0 toward the second wavelength converter 322 in the tenth unit period P0. Under the control in the example in FIG. 17, the first emission period, the third emission period, and the second emission period do not overlap one another with a non-emission period in one unit period P0 between the third emission period and the second emission period in an operation period Pc1. The temperature of each of the first wavelength converter 321, the second wavelength converter 322, and the third wavelength converter 323 is thus, for example, less likely to increase. Irradiation of excitation light L0 may start toward the second wavelength converter 322 after the irradiation of excitation light L0 toward the third wavelength converter 323 is complete with the substrate 31 being cooled for a short time. The temperature of the second wavelength converter 322 is thus, for example, less likely to increase, possibly reducing deterioration of the phosphors in the second wavelength converter 322.

In the example in FIG. 18, the controller 51 causes, in an operation period Pc1, the first light source 211 to emit excitation light L0 toward the first wavelength converter 321 in the first to seventh unit periods P0, the third light source 213 to emit excitation light L0 toward the third wavelength converter 323 in the first to fifth unit periods P0, and the second light source 212 to emit excitation light L0 toward the second wavelength converter 322 in the tenth unit period P0. Under the control in the example in FIG. 18, for example, the second emission period does not overlap both the first emission period and the third emission period, and irradiation of excitation light L0 may start toward the second wavelength converter 322, with the substrate 31 being cooled in a particularly long non-emission period in two unit periods P0 between the first emission period including the third emission period and the second emission period. The temperature of the second wavelength converter 322 is thus, for example, less likely to increase, possibly reducing deterioration of the phosphors in the second wavelength converter 322.

### 2. Other Embodiments

The present disclosure is not limited to the first embodiment described above and may be changed in various manners without departing from the spirit and scope of the present disclosure.

In the first embodiment described above, the first phosphor may be, for example, a red phosphor, a green phosphor, or a blue phosphor. The second phosphor may be, for example, a red phosphor, a green phosphor, or a blue phosphor different from the first phosphor. The third phosphor may be, for example, a red phosphor, a green phosphor, or a blue phosphor different from the first phosphor and the second phosphor.

In the first embodiment described above, for example, the first phosphor, the second phosphor, and the third phosphor may be phosphors that each emit a different color of fluorescence such as a blue-green phosphor or a yellow phosphor in response to excitation light L0. The blue-green phosphor emits blue-green fluorescence in response to excitation light L0. The yellow phosphor emits yellow fluorescence in response to excitation light L0. The blue-green phosphor is, for example, a phosphor that emits fluorescence with a peak wavelength at about 495 nm in response to excitation light L0. The blue-green phosphor material is, for example, (Sr, Ba, Ca)₅(PO₄)₃Cl:Eu or Sr₄Al₁₄O₂₅:Eu. The yellow phosphor is, for example, a phosphor that emits fluorescence with a peak wavelength in a range of about 570 to 590 nm in response to excitation light L0. The yellow phosphor material is, for example, SrSi₂(O, Cl)₂N₂:Eu. The ratio of the elements in parentheses herein may be changed as appropriate without deviating from the molecular formulas.

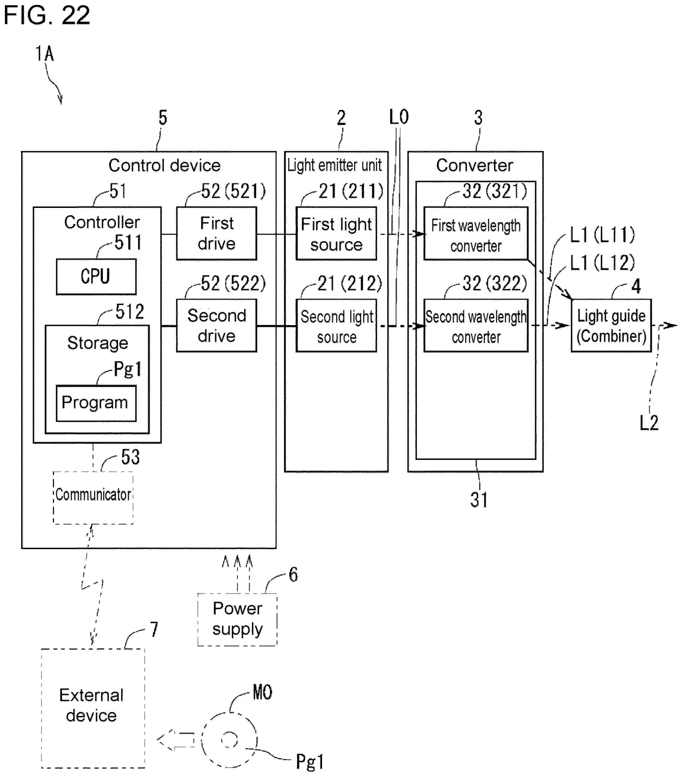

In the first embodiment described above, for example, the multiple light sources 21 may be two light sources 21. For example, the multiple light sources 21 may include a first light source 211 and a second light source 212, the multiple wavelength converters 32 may include a first wavelength converter 321 and a second wavelength converter 322, and the multiple drives 52 may include a first drive 521 and a second drive 522. FIG. 22 is a schematic diagram of an illumination system 1A according to a first variation. The illumination system 1A has the same structure as the structure of the illumination system 1 according to the first embodiment without the third drive 523, the third light source 213, and the third wavelength converter 323.

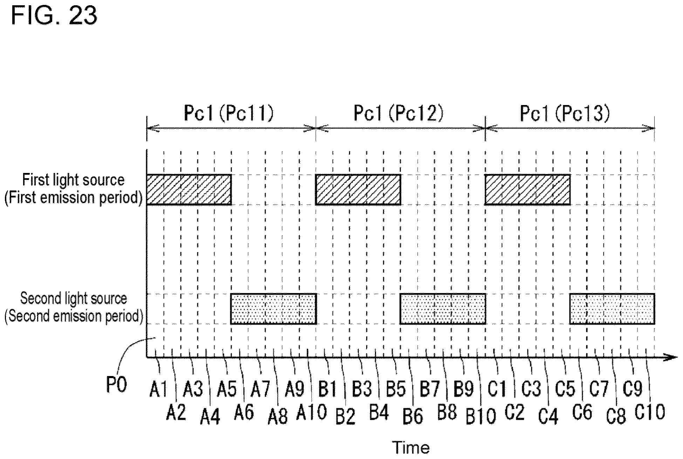

FIG. 23 is a graph showing the period during which each of the light sources 21 emits excitation light L0 in the illumination system 1A according to the first variation. FIG. 23 shows, as in FIGs. 5 to 18, with the horizontal axis indicating time, periods during which each of the light sources 21 emits excitation light L0 in three continuous operation periods Pc1 repeated multiple times. In FIG. 23, as in FIGs. 5 to 18, the first emission period is indicated by a square hatched with diagonal lines rising to the upper right, and the second emission period is indicated by a square hatched with dots.

As illustrated in FIG. 23, an operation period Pc1 includes the first emission period during which the first light source 211 emits excitation light L0 toward the first wavelength converter 321 and the second emission period during which the second light source 212 emits excitation light L0 toward the second wavelength converter 322. When the controller 51 causes each light source 21 to repeat emission and non-emission of excitation light L0 in constant cycles, the controller 51 may cause, in an operation period Pc1, the second light source 212 to emit no excitation light L0 toward the second wavelength converter 322 for at least a portion of the first emission period during which the first light source 211 emits excitation light L0 toward the first wavelength converter 321. The controller 51 may cause, for example, in an operation period Pc1, the first light source 211 to emit no excitation light L0 toward the first wavelength converter 321 for at least a portion of the second emission period during which the second light source 212 emits excitation light L0 toward the second wavelength converter 322.

This control also causes, for example, the first emission period and the second emission period to shift relative to each other in an operation period Pc1. This control shortens, for example, the period during which the first wavelength converter 321 and the second wavelength converter 322 are heated simultaneously. The temperatures of the first wavelength converter 321 and the second wavelength converter 322 are thus less likely to increase. This reduces deterioration of the phosphors in the first wavelength converter 321 and the second wavelength converter 322. Thus, the illumination system 1A that can adjust the light color may reduce, for example, deterioration of the phosphors.

In the example in FIG. 23, the controller 51 causes, in an operation period Pc1, the first light source 211 to emit excitation light L0 toward the first wavelength converter 321 in the first to fifth unit periods P0, and the second light source 212 to emit excitation light L0 toward the second wavelength converter 322 in the sixth to tenth unit periods P0. Under the control in the example in FIG. 23, for example, the first emission period and the second emission period do not overlap each other. The temperatures of the first wavelength converter 321 and the second wavelength converter 322 are thus less likely to increase. This reduces deterioration of the phosphors in the first wavelength converter 321 and the second wavelength converter 322.

In the first embodiment described above, for example, the multiple light sources 21 may be four or more light sources 21. In other words, the multiple light sources 21 may be two or more light sources 21. In this case, the multiple wavelength converters 32 may be two or more wavelength converters 32. The multiple drives 52 may also be two or more drives 52.

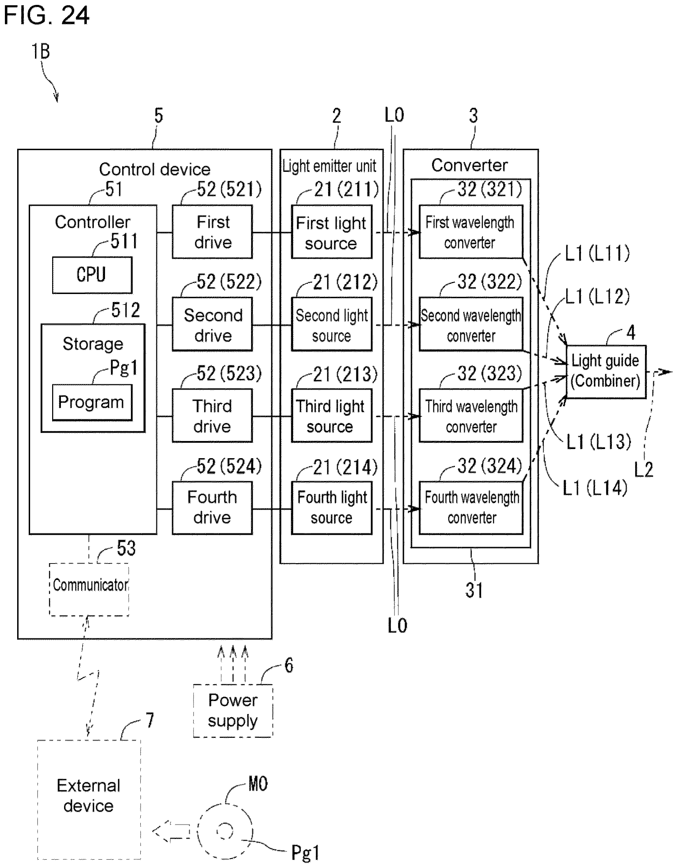

FIG. 24 is a schematic diagram of an illumination system 1B according to a second variation. The illumination system 1B has the same structure as the structure of the illumination system 1 according to the first embodiment additionally including a fourth light source 214, a fourth wavelength converter 324, and a fourth drive 524. In this example, the multiple light sources 21 include a first light source 211, a second light source 212, a third light source 213, and a fourth light source 214. The multiple wavelength converters 32 include a first wavelength converter 321, a second wavelength converter 322, a third wavelength converter 323, and a fourth wavelength converter 324. The fourth wavelength converter 324 can emit, for example, fluorescence (also referred to as fourth fluorescence) L14 with a fourth wavelength spectrum different from the first to third wavelength spectra in response to excitation light L0 from the fourth light source 214. The fourth wavelength converter 324 includes, for example, a phosphor (also referred to as a fourth phosphor) that emits fluorescence of a fourth color in response to excitation light L0. The fluorescence of the fourth color has a color different from the first to third colors. The fourth phosphor may be a phosphor that emits fluorescence of a color such as a blue-green phosphor or a yellow phosphor in response to excitation light L0. The multiple drives 52 include a first drive 521, a second drive 522, a third drive 523, and a fourth drive 524. The fourth drive 524 can drive, for example, the fourth light source 214 in response to an instruction from the controller 51.

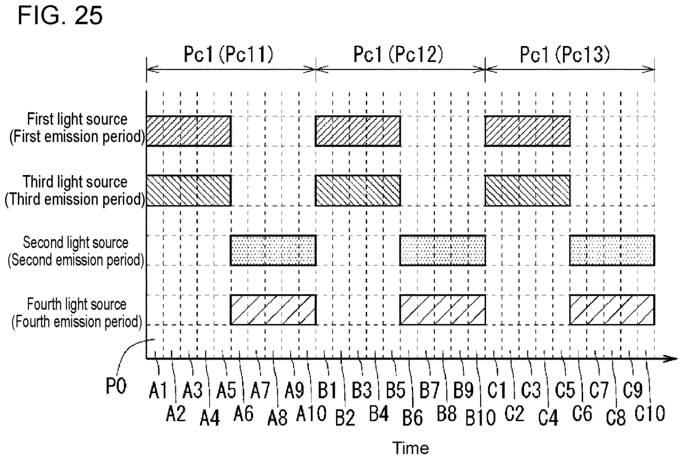

FIG. 25 is a graph showing the period during which each of the light sources 21 emits excitation light L0 in the illumination system 1B according to the second variation. FIG. 25 shows, as in FIGs. 5 to 18, with the horizontal axis indicating time, periods during which each of the light sources 21 emits excitation light L0 in three continuous operation periods Pc1 repeated multiple times. In FIG. 25, as in FIGs. 5 to 18, the first emission period is indicated by a square hatched with diagonal lines rising to the upper right, the third emission period is indicated by a square hatched with diagonal lines rising to the upper left, and the second emission period is indicated by a square hatched with dots. In FIG. 25, the period during which the fourth light source 214 emits excitation light L0 (also referred to as a fourth emission period) in an operation period of one cycle is indicated by a square hatched with diagonal lines widely spaced and rising to the upper right.

As illustrated in FIG. 25, an operation period Pc1 includes the first emission period, the second emission period, the third emission period, and the fourth emission period. When the controller 51 causes each light source 21 to repeat emission and non-emission of excitation light L0 in constant cycles, the controller 51 may cause, in an operation period Pc1, the second light source 212 to emit no excitation light L0 toward the second wavelength converter 322 for at least a portion of the first emission period during which the first light source 211 emits excitation light L0 toward the first wavelength converter 321. The controller 51 may cause, for example, in an operation period Pc1, the first light source 211 to emit no excitation light L0 toward the first wavelength converter 321 for at least a portion of the second emission period during which the second light source 212 emits excitation light L0 toward the second wavelength converter 322.

This control also causes, for example, the first emission period and the second emission period to shift relative to each other in an operation period Pc1. This control shortens, for example, the period during which the first wavelength converter 321 and the second wavelength converter 322 are heated simultaneously. The temperatures of the first wavelength converter 321 and the second wavelength converter 322 are thus less likely to increase. This reduces deterioration of the phosphors in the first wavelength converter 321 and the second wavelength converter 322. Thus, the illumination system 1B that can adjust the light color may reduce, for example, deterioration of the phosphors.

In the example in FIG. 25, the controller 51 causes, in an operation period Pc1, the first light source 211 to emit excitation light L0 toward the first wavelength converter 321 and the third light source 213 to emit excitation light L0 toward the third wavelength converter 323 in the first to fifth unit periods P0, and the second light source 212 to emit excitation light L0 toward the second wavelength converter 322 and the fourth light source 214 to emit excitation light L0 toward the fourth wavelength converter 324 in the sixth to tenth unit periods P0. Under the control in the example in FIG. 25, for example, the first emission period and the third emission period do not overlap the second emission period and the fourth emission period. The temperatures of the first wavelength converter 321, the second wavelength converter 322, the third wavelength converter 323, and the fourth wavelength converter 324 are thus less likely to increase. This reduces deterioration of the phosphors in the first wavelength converter 321, the second wavelength converter 322, the third wavelength converter 323, and the fourth wavelength converter 324.

In the first embodiment described above, each wavelength converter 32 may include, for example, numerous particles of multiple different phosphors. In this case, the wavelength converters 32 may include multiple different phosphors with different ratios of numerous particles.

In the first embodiment described above, for example, the control device 5 may include a communicator 53 that can communicate with an external device 7, as indicated by the two-dot-dash lines in FIGs. 1, 22, and 24. The communicator 53 serves a communication circuit. In this case, the controller 51 may control the communicator 53 to obtain a program Pg1 or various data items from the external device 7. The communicator 53 may perform, for example, wireless or wired communication with the external device 7. The communicator 53 may communicate with, for example, the external device 7 based on any telecommunications standard such as universal serial bus (USB), radio frequency identifier (RFID), or Wi-Fi. The external device 7 may include, for example, a reader such as a drive or a port with a portable storage medium M0 storing the program Pg1 attached in a detachable manner. The external device 7 may read, for example, the program Pg1 stored in the storage medium M0 with the storage medium M0 attached to the reader. The storage medium M0 stores, for example, the program Pg1, and serves as a non-transitory computer-readable storage medium. The storage medium M0 may be, for example, an optical disc, a magnetic disk, or a nonvolatile memory.

In the first embodiment described above, for example, the light emitter unit 2 may be spaced from the converter 3. In this case, for example, excitation light L0 emitted from each light source 21 may be irradiated toward the corresponding wavelength converter 32 through an optical transmission path such as an optical fiber.

In the first embodiment and the variations described above, the illumination systems 1, 1A, and 1B may each include, for example, multiple sets of the light emitter unit 2, the converter 3, and the light guide 4. In this case, for example, a single control device 5 may control the driving of each light emitter unit 2.

The components described in the first embodiment and the variations described above may be entirely or partially combined as appropriate unless any contradiction arises.

### REFERENCE SIGNS

1, 1A, 1B illumination system
2 light emitter unit
21 light source
211 first light source
212 second light source
213 third light source
214 fourth light source
3 converter
31 substrate
32 wavelength converter
321 first wavelength converter
322 second wavelength converter
323 third wavelength converter
324 fourth wavelength converter
4 light guide
5 control device
51 controller
511 CPU
512 storage
52 drive
521 first drive
522 second drive
523 third drive
524 fourth drive
6 power supply
L0 excitation light
L1 fluorescence
L11 first fluorescence
L12 second fluorescence
L13 third fluorescence
L14 fourth fluorescence
L2 illumination light
M0 storage medium
P0 unit period
Pc1 operation period of one cycle
Pg1 program

## Claims

1. An illumination system, comprising:
a plurality of light sources configured to emit excitation light, the plurality of light sources including a first light source and a second light source;
a substrate;
a plurality of wavelength converters on the substrate, the plurality of wavelength converters including a first wavelength converter configured to emit fluorescence with a first wavelength spectrum in response to excitation light from the first light source and a second wavelength converter configured to emit fluorescence with a second wavelength spectrum different from the first wavelength spectrum in response to excitation light from the second light source;
a light guide configured to guide fluorescence emitted from the plurality of wavelength converters; and
a controller configured to cause each of the plurality of light sources to repeat emission and non-emission of excitation light in constant cycles,
wherein when the controller causes each of the plurality of light sources to repeat emission and non-emission of excitation light in the constant cycles, in an operation period of one cycle from a first start timing at which the first light source starts a first irradiation toward the first wavelength converter with excitation light to a second start timing at which the first light source starts a second irradiation subsequent to the first irradiation toward the first wavelength converter with excitation light, the controller causes the second light source to emit no excitation light toward the second wavelength converter for at least a portion of a first emission period during which the first light source emits excitation light toward the first wavelength converter, and the controller causes the first light source to emit no excitation light toward the first wavelength converter for at least a portion of a second emission period during which the second light source emits excitation light toward the second wavelength converter.

2. The illumination system according to claim 1, wherein
the plurality of light sources includes a third light source configured to emit excitation light,
the plurality of wavelength converters includes a third wavelength converter configured to emit fluorescence with a third wavelength spectrum different from the first wavelength spectrum and the second wavelength spectrum in response to excitation light from the third light source, and
the operation period of one cycle includes the first emission period, the second emission period, and a third emission period during which the third light source emits excitation light toward the third wavelength converter.

3. The illumination system according to claim 2, wherein
in the operation period of one cycle, the controller causes the third light source to emit no excitation light toward the third wavelength converter for at least a portion of the first emission period, causes the first light source to emit no excitation light toward the first wavelength converter for at least a portion of the third emission period, causes the third light source to emit no excitation light toward the third wavelength converter for at least a portion of the second emission period, and causes the second light source to emit no excitation light toward the second wavelength converter for at least a portion of the third emission period.

4. The illumination system according to claim 3, wherein
the controller causes the second light source and the third light source to emit no excitation light toward the second wavelength converter and the third wavelength converter in the first emission period, causes the first light source and the second light source to emit no excitation light toward the first wavelength converter and the second wavelength converter in the third emission period, and causes the first light source and the third light source to emit no excitation light toward the first wavelength converter and the third wavelength converter in the second emission period.

5. The illumination system according to claim 4, wherein
in the operation period of one cycle, the controller causes the first light source, the second light source, and the third light source to emit no excitation light toward the first wavelength converter, the second wavelength converter, and the third wavelength converter in a first non-emission period between the first emission period and the third emission period, in a second non-emission period between the third emission period and the second emission period, and in a third non-emission period after the second emission period.

6. The illumination system according to claim 5, wherein
the second non-emission period is longer than the first non-emission period and the third non-emission period.

7. The illumination system according to claim 4, wherein
in the operation period of one cycle, the controller causes, between the first emission period and the third emission period, no first non-emission period during which the first light source, the second light source, and the third light source emit no excitation light toward the first wavelength converter, the second wavelength converter, and the third wavelength converter, and the controller causes, in a second non-emission period between the third emission period and the second emission period and in the third non-emission period after the second emission period, the first light source, the second light source, and the third light source to emit no excitation light toward the first wavelength converter, the second wavelength converter, and the third wavelength converter, and
the second non-emission period is longer than the third non-emission period.

8. The illumination system according to claim 2, wherein
the controller causes, in the operation period of one cycle, the first light source and the third light source to emit no excitation light toward the first wavelength converter and the third wavelength converter for at least a portion of the second emission period.

9. The illumination system according to claim 8, wherein
the controller causes, in the operation period of one cycle, the third light source to emit excitation light toward the third wavelength converter for at least a portion of the first emission period.

10. The illumination system according to claim 9, wherein
in the operation period of one cycle, the controller causes the third light source to start or end emission of excitation light toward the third wavelength converter in the first emission period, causes the first light source to start or end emission of excitation light toward the first wavelength converter in the third emission period, or causes the first light source and the third light source to simultaneously start or end emission of excitation light.

11. The illumination system according to claim 10, wherein
in the operation period of one cycle, the controller causes, after the second emission period, no non-emission period during which the first light source, the second light source, and the third light source emit no excitation light toward the first wavelength converter, the second wavelength converter, and the third wavelength converter.

12. The illumination system according to claim 10 or claim 11, wherein
the controller causes, in the operation period of one cycle, the first light source and the third light source to emit no excitation light toward the first wavelength converter and the third wavelength converter in the second emission period.

13. The illumination system according to claim 12, wherein
the controller causes, in the operation period of one cycle, the first light source, the second light source, and the third light source to emit no excitation light toward the first wavelength converter, the second wavelength converter, and the third wavelength converter in a non-emission period between the first emission period and the second emission period and between the third emission period and the second emission period.

14. The illumination system according to any one of claims 2 to 13, wherein
the first emission period, the second emission period, and the third emission period have a same length in the operation period of one cycle.

15. The illumination system according to any one of claims 2 to 13, wherein
the first emission period, the second emission period, and the third emission period have different lengths in the operation period of one cycle.

16. A control method for an illumination system including a plurality of light sources configured to emit excitation light and including a first light source and a second light source, a substrate, a plurality of wavelength converters on the substrate and including a first wavelength converter configured to emit fluorescence with a first wavelength spectrum in response to excitation light from the first light source and a second wavelength converter configured to emit fluorescence with a second wavelength spectrum different from the first wavelength spectrum in response to excitation light from the second light source, a light guide configured to guide fluorescence emitted from the plurality of wavelength converters, and a controller configured to cause each of the plurality of light sources to repeat emission and non-emission of excitation light, the control method comprising:
(a) causing, with the controller, each of the plurality of light sources to repeat emission and non-emission of excitation light in constant cycles,
wherein in (a), in an operation period of one cycle from a first start timing at which the first light source starts a first irradiation toward the first wavelength converter with excitation light to a second start timing at which the first light source starts a second irradiation subsequent to the first irradiation toward the first wavelength converter with excitation light, the controller causes the second light source to emit no excitation light toward the second wavelength converter for at least a portion of a first emission period during which the first light source emits excitation light toward the first wavelength converter, and the controller causes the first light source to emit no excitation light toward the first wavelength converter for at least a portion of a second emission period during which the second light source emits excitation light toward the second wavelength converter.

17. The control method according to claim 16, wherein
the plurality of light sources includes a third light source being configured to emit excitation light,
the plurality of wavelength converters includes a third wavelength converter configured to emit fluorescence with a third wavelength spectrum different from the first wavelength spectrum and the second wavelength spectrum in response to excitation light from the third light source, and
in (a), the controller causes, in the operation period of one cycle, the third light source to emit excitation light toward the third wavelength converter.

18. A program executable by a controller in an illumination system including a plurality of light sources configured to emit excitation light and including a first light source and a second light source, a substrate, a plurality of wavelength converters on the substrate and including a first wavelength converter configured to emit fluorescence with a first wavelength spectrum in response to excitation light from the first light source and a second wavelength converter configured to emit fluorescence with a second wavelength spectrum different from the first wavelength spectrum in response to excitation light from the second light source, a light guide configured to guide fluorescence emitted from the plurality of wavelength converters, and the controller configured to cause each of the plurality of light sources to repeat emission and non-emission of excitation light, the program causing the illumination system to function as the illumination system according to any one of claims 1 to 15.
